# FASCICULE DE BREVET EUROPEEN

(11) **EP 1 607 760 B1**
(45) Date de publication et mention de la délivrance du brevet: **22.07.2009**
(21) Numéro de dépôt: 05360019.3
(22) Date de dépôt: 27.05.2005
(51) Int. Cl.: G01R 33/36

(54) **Circuit d'alimentation d'une bobine et sonde et spectomètre RMN comportant un tel circuit**
Schaltkreis zur Stromeinspeisung in eine Spule und NMR-Spektrometer mit einem solchen Schaltkreis
Circuit for supplying power to a coil and NMR spectrometer comprising such a circuit

(30) Priorité: 18.06.2004 FR 0406663
(43) Date de publication de la demande: 21.12.2005
(73) Titulaire: Bruker Biospin SA, 67160 Wissembourg (FR)
(72) Inventeur: Weiss, Michel, 67240 Gries (FR); Martinache, Laurent, 67500 Marienthal (FR); Gonella, Olivier, 67240 Bischwiller (FR)
(74) Mandataire: Nuss, Pierre

(56) Documents cités:
- EP-A- 0 073 614
- EP-A- 0 890 848
- EP-A- 1 249 709
- CROSS V.R. ET AL.: "Single coil probe with transmission-line tuning for nuclear magnetic double resonance" REVIEW OF SCIENTIFIC INSTRUMENTS, vol. 47, 1976, pages 1486-1488, XP008043907 ISSN: 0034-6748

## Description

La présente invention concerne le domaine des alimentations électriques de précision, en particulier dans le domaine de la Résonance Magnétique Nucléaire, et a pour objet un circuit d'alimentation d'une bobine, en particulier une bobine d'échantillon, ainsi qu'une sonde RMN et un spectromètre RMN comprenant un tel circuit.

Dans certaines applications, il est nécessaire de disposer d'une alimentation très précise en termes de caractéristiques et de propriétés des courants délivrés, ce pour des circuits utilisés dans des circonstances ou des contextes particuliers ou extrêmes.

Tel est notamment le cas pour l'alimentation des bobines d'échantillon ou RMN, situées au coeur des spectromètres RMN.

En particulier dans les expériences de RMN du solide, il est nécessaire de disposer d'un maximum de courant précisément au niveau de la région recevant l'échantillon (soumis à une rotation à plusieurs dizaines de milliers de tours par seconde), c'est-à-dire au milieu de la bobine.

Divers systèmes d'alimentation ont déjà été proposés pour répondre au besoin précité.

Toutefois, ces systèmes connus ne donnent pas entièrement satisfaction et présentent des limitations.

En effet, l'analyse multifréquencielle se généralise, d'où la nécessité de disposer de plusieurs voies d'alimentations de la bobine, à des fréquences différentes déterminées (correspondant chacune à un type de noyaux à détecter), répondant chacune à la condition de maximum de courant précité.

Les systèmes d'alimentation multifréquence proposés actuellement (voir par exemple US 5 861 748) présentent une structure très compliquée (souvent très difficile à loger aisément dans le volume cylindrique étriqué dévolu à la réception de la sonde comprenant la bobine), chaque voie d'alimentation devant comporter des moyens d'isolation par rapport aux influences des autres voies.

De plus, ces systèmes connus sont très peu souples, voire figés, en termes de variation de fréquence des différentes voies ou de changement du nombre de voies (ajout d'une voie ou suppression d'une voie). Chaque modification au niveau d'une voie se répercute au niveau de toutes les autres voies existantes dans le système et nécessite un ajustement ou des changements au niveau de ces dernières, qui eux-mêmes ont à nouveau des répercussions additionnelles, ce notamment du fait de leur structure dissymétrique.

Par le document EP-A-1 249 709, on connaît un circuit d'alimentation selon le préambule de la revendication 1.

Toutefois, ce circuit connu ne permet pas de fournir une alimentation avec un maximum d'intensité toujours situé exactement au milieu de la bobine HF ou bobine d'échantillon, pour des fréquences d'excitation différentes.

La présente invention a pour objet de proposer une solution simple permettant de surmonter au moins certains des inconvénients précités.

Cet objet est atteint par l'invention grâce aux caractéristiques de la partie caractérisante de la revendication 1.

L'invention sera mieux comprise, grâce à la description ci-après, qui se rapporte à des modes de réalisation préférés, donnés à titre d'exemples non limitatifs, et expliqués avec référence aux dessins schématiques annexés, dans lesquels :
les figures 1A et 1B sont des représentations schématiques, partiellement symboliques, de deux variantes d'un premier mode de réalisation d'un circuit d'alimentation selon l'invention, réalisant une alimentation à une seule fréquence ;
les figures 2, 3A et 3B sont des représentations schématiques, partiellement symboliques, de trois variantes d'un second mode de réalisation d'un circuit d'alimentation selon l'invention, réalisant des alimentations à trois fréquences différentes ;
les figures 4, 5A et 5B sont des représentations schématiques, partiellement symboliques, de trois variantes d'un troisième mode de réalisation d'un circuit d'alimentation selon l'invention, réalisant des alimentations à trois fréquences différentes ;
la figure 5C est une représentation schématique, partiellement symbolique, d'une variante supplémentaire du troisième mode de réalisation de l'invention, réalisant des alimentations à deux fréquences différentes :
la figure 6 est une représentation schématique d'un mode de réalisation d'un couplage magnétique variable entre un circuit oscillant et un circuit d'alimentation primaire correspondant, faisant partie d'un circuit d'alimentation selon l'invention ;
la figure 7 est une représentation schématique d'un mode de réalisation des ensembles de filtres réjecteurs faisant partie du circuit d'alimentation représenté sur la figure 3B ;
les figures 8A et 8B sont des vues en perspective d'un autre mode de réalisation des capacités variables d'une paire de filtres réjecteurs faisant partie du circuit d'alimentation représenté sur la figure 3B ;
la figure 9 est une vue en perspective de la paire de capacités des figures 8A et 8B intégrées dans une partie d'une sonde RMN multifréquence selon l'invention ;
les figures 10A, 10B et 10C sont des vues respectivement en élévation latérale (fig. 10A et 10B) et en perspective (fig. 10C), à des échelles différentes, d'une sonde RMN multifréquence, pourvue d'un circuit d'alimentation selon l'invention, et,
la figure 11 est une vue en coupe longitudinale d'un exemple de réalisation d'une portion de ligne triaxiale.

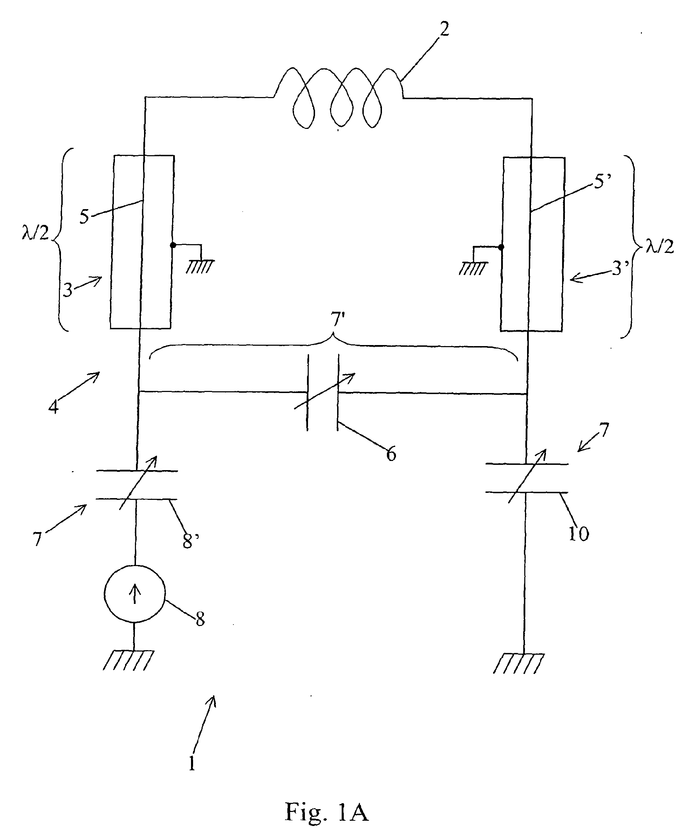

Les figures 1A, 1B, 2, 3A, 3B, 4, 5A, 5B et 5C montrent chacune un circuit 1 d'alimentation d'une bobine 2, notamment d'une bobine HF ou bobine d'échantillon, comprenant deux portions de ligne d'alimentation ou de transmission 3 et 3' reliées chacune à l'une des deux extrémités de cette bobine 2, lesdites portions de ligne 3, 3' formant avec ladite bobine 2 un circuit oscillant ou premier circuit oscillant 4 présentant une fréquence de résonance déterminée.

Les deux portions de ligne 3 et 3' comportent chacune au moins deux conducteurs 5, 5' ; 5", 5"', dont l'un 5, 5' est relié à la bobine 2, et présentent entre elles des structures identiques et des longueurs de conducteurs reliés identiques. Conformément à l'invention, le circuit d'alimentation 1 est caractérisé en ce que chacune de ces longueurs identiques est sensiblement un multiple de la moitié de la longueur d'onde de résonance dudit circuit oscillant 4, en ce que les conducteurs 5, 5' reliés à la bobine 2 à l'une de leurs extrémités sont reliés entre eux à leur autre extrémité par un circuit ou composant d'accord symétrique réglable 6 complétant ce circuit oscillant 4, et en ce que ledit circuit oscillant 4 à structure symétrique est alimenté par un circuit d'alimentation primaire 7 par l'intermédiaire d'un transfert d'énergie par couplage magnétique, capacitif ou magnéto-capacitif dudit circuit d'alimentation primaire 7 avec les deux conducteurs 5, 5' reliés à la bobine 2 et au circuit ou composant d'accord 6.

Selon une première variante d'un premier mode de réalisation, représentée sur la figure 1A des dessins annexés, le circuit d'alimentation primaire 7 peut être partiellement confondu avec le premier circuit oscillant 4, en intégrant une partie de circuit 7' commune avec ce premier circuit oscillant, et comprendre, d'une part, un générateur radiofréquence 8 ajusté à la fréquence de résonance déterminée du premier circuit oscillant 4 et relié audit premier circuit oscillant 4 au niveau d'une borne du circuit ou composant d'accord symétrique réglable 6 par l'intermédiaire d'une capacité de couplage 8' et, d'autre part, un circuit ou composant d'adaptation 10 relié à l'autre borne du circuit ou composant d'accord symétrique réglable 6, le composant d'adaptation 10 et le composant d'accord symétrique réglable 6 faisant partie des deux circuits 4 et 7, consistant en des capacités et le générateur 8 fonctionnant de manière continue, par intermittence ou de manière pulsée.

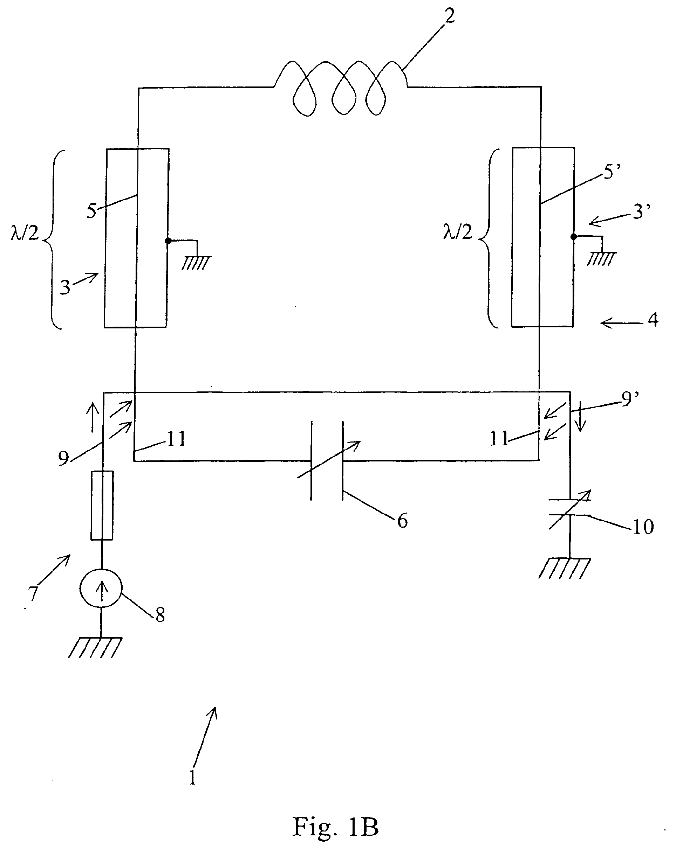

Selon une seconde variante d'un premier mode de réalisation, représentée sur la figure 1B des dessins annexés, le circuit d'alimentation primaire 7 consiste en un circuit séparé et comprend, en plus d'un générateur radiofréquence 8 ajusté à la fréquence de résonance déterminée et du ou des éléments 9, 9' participant au couplage avec les deux conducteurs 5, 5' d'une ou des portions de ligne 3, 3' relié à la bobine 2 et au circuit ou composant d'accord 6, également un circuit ou composant d'adaptation 10, destiné à optimiser le couplage et à en limiter certains effets au niveau du circuit d'alimentation primaire 7, le générateur 8 fonctionnant de manière continue, par intermittence ou de manière pulsée.

En relation avec cette seconde variante, le couplage consiste préférentiellement en un couplage essentiellement de nature magnétique et en ce que le circuit ou composant d'adaptation 10 est préférentiellement une capacité réglable destinée à annuler la réactance inductive au niveau du circuit d'alimentation primaire 7.

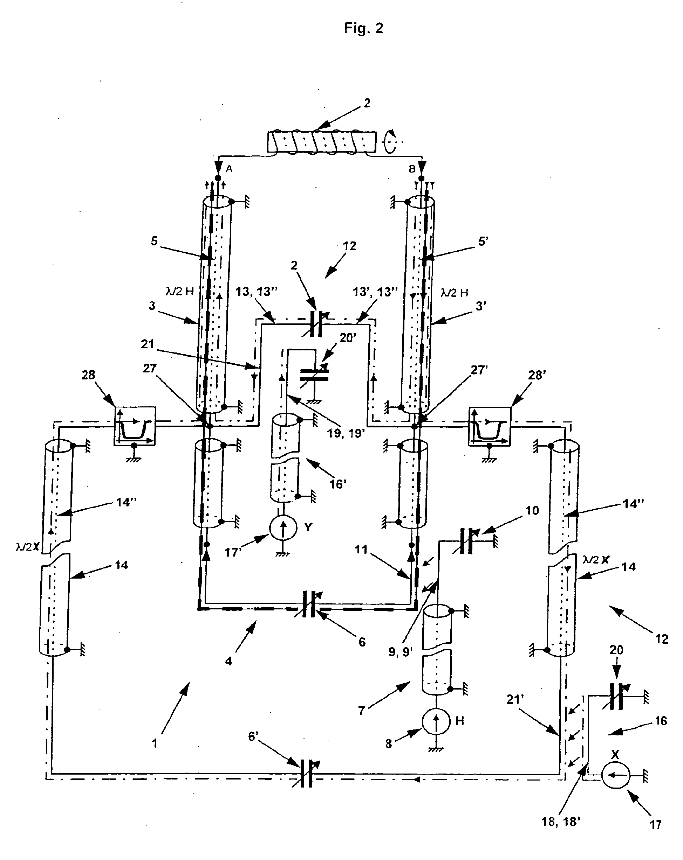

Comme le montre la figure 1A dans le cadre d'un couplage capacitif et la figure 2 dans le cadre d'un couplage essentiellement de nature magnétique, il est possible de mettre en oeuvre un unique couplage symétrique ou asymétrique [en prévoyant dans ce dernier cas des mesures de compensation et de symétrisation dans le circuit oscillant 4 (ou 12, 12') concerné].

Toutefois, de manière préférée, le transfert d'énergie par couplage entre le circuit d'alimentation primaire 7 et le circuit oscillant 4 consiste en un couplage double et affecte de manière symétrique et équivalente les conducteurs 5 et 5' ; 5", 5"' reliés à la bobine 2 des deux portions de ligne de transmission 3 et 3' (voir figures 1B, 3A, 3B, 4, 5A, 5B et 5C).

Conformément à une première réalisation pratique d'un couplage, préférentiellement symétrique, de nature essentiellement magnétique, et comme représenté aux figures 1B, 2, 3A, 3B, 4, 5B et 5C, le ou chacun des deux couplage(s) réalisant le transfert d'énergie consiste en un couplage principalement magnétique entre, d'une part, un segment 11 d'un conducteur 5, 5' relié à la bobine 2 d'une des portions de ligne 3, 3' du circuit oscillant 4 et, d'autre part, un segment 9, 9' de la ligne reliant le générateur 8 au composant d'adaptation 10 dans le circuit d'alimentation primaire 7, ces deux segments 11 et 9, 9' de longueurs déterminées étant disposés parallèlement et à proximité l'un de l'autre et formant des lignes de Lecher.

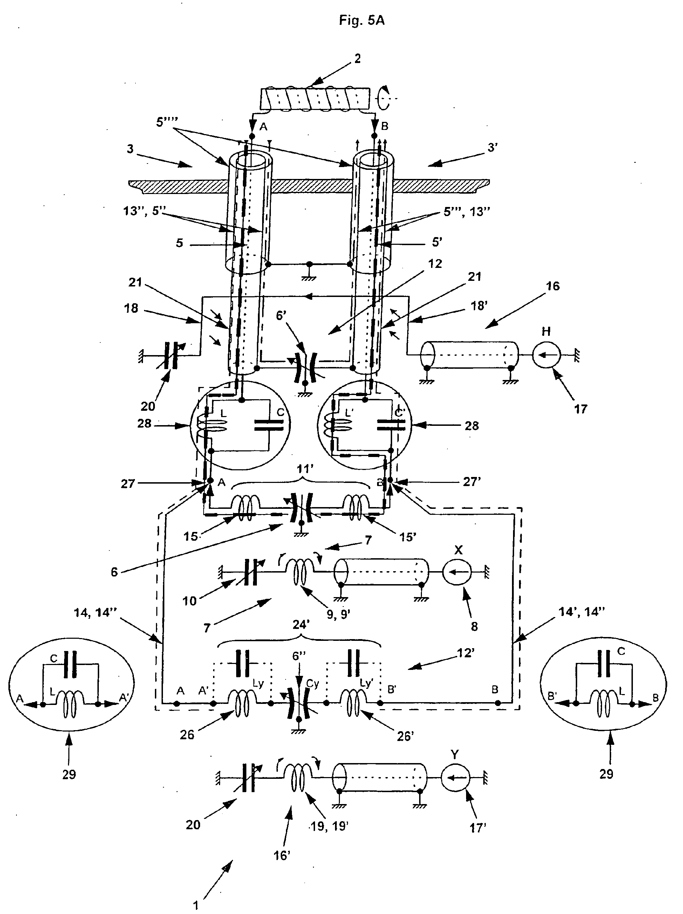

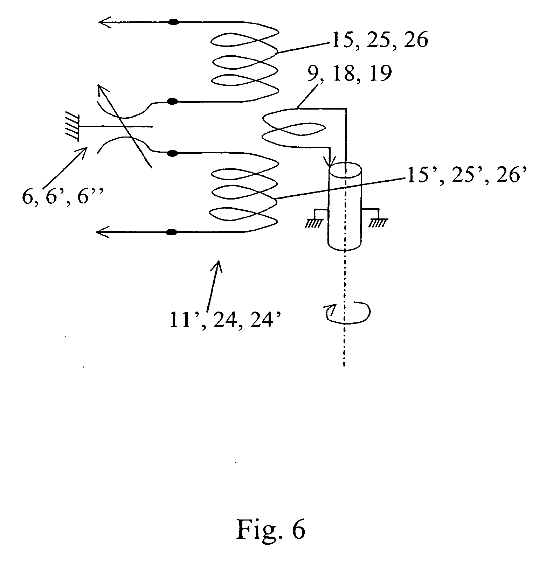

Conformément à une seconde réalisation pratique d'un couplage, préférentiellement symétrique, de nature essentiellement magnétique, et comme représenté aux figures 5A et 6, le couplage réalisant le transfert d'énergie consiste en un couplage magnéto-capacitif, symétrique ou asymétrique, entre, d'une part, un solénoïde 9 monté en série dans le circuit d'alimentation primaire 7 et, d'autre part, un ensemble 11' capacité/inductance(s) monté en série dans le circuit oscillant 4, ladite capacité pouvant correspondre au composant d'accord 6 et les inductances comprendre deux inductances équivalentes 15, 15' montées en série de part et d'autre de ladite capacité 6, en faisant éventuellement partie chacune d'un circuit LC.

En accord avec un mode de réalisation très avantageux de l'invention, autorisant des alimentations avec au moins deux fréquences différentes, le circuit d'alimentation comprend au moins un circuit oscillant supplémentaire 12, 12' présentant une fréquence de résonance différente de celle du premier circuit oscillant 4 et formé, le cas échéant chacun, par la bobine 2, des parties mutuellement équivalentes d'un conducteur 5, 5', 5", 5"' des deux portions de ligne 3, 3' du premier circuit oscillant 4 et, éventuellement, deux portions de ligne de transmission additionnelles 13, 13' ; 14, 14' reliées chacune par l'une des extrémités de leur au moins un conducteur 13", 14" respectif à l'un des conducteurs 5, 5" ; 5', 5"' de l'une des deux portions de ligne 3, 3' précitées et présentant entre elles des structures et des longueurs identiques. La somme de la longueur de chacune desdites deux portions de lignes de transmission additionnelles 13, 13' ; 14, 14' et de la longueur de la partie de conducteur 5, 5' ;5", 5"' respectivement associée de l'une des deux portions de ligne 3, 3' est un multiple de la demi-longueur d'onde de résonance du circuit oscillant supplémentaire considéré 12, 12' et les lignes de transmission additionnelles 13, 13' ; 14, 14' sont reliées à leur autre extrémité à un circuit ou composant d'accord 6', 6". Ledit au moins un ou chaque circuit oscillant supplémentaire 12, 12' est alimenté par un circuit d'alimentation primaire 16, 16' propre correspondant, ce par l'intermédiaire d'un transfert d'énergie par couplage magnétique, capacitif ou magnéto-capacitif de ce circuit d'alimentation primaire 16, 16' respectif correspondant avec au moins un des conducteurs 13" ; 14" reliés aux ou faisant partie des portions de ligne 3, 3' du premier circuit oscillant 4, d'au moins une des deux portions de ligne de transmission additionnelles 13, 13' ; 14, 14' (Figures 2, 3A, 3B, 4, 5A, 5B et 5C).

Généralement, les analyses spectrométriques nécessitent la fourniture de trois fréquences d'excitation différentes pour la détection de trois types de noyaux. Ces trois canaux de fréquences comprennent généralement une fréquence élevée correspondant à la résonance du noyau H (proton - dénommé canal H) et deux autres canaux englobant les noyaux résonants dans une bande de fréquences plus basses. Cette bande de fréquences plus basses est divisée en deux sous-bandes, la sous-bande Y correspondant à une sous-bande basse et la sous-bande X correspondant à la sous-bande haute (dénommées respectivement canal Y et canal X).

Sur les figures des dessins annexés, certaines indications supplémentaires (en plus des références numériques) permettent d'identifier les composants ou parties de circuit appartenant ou participant aux voies d'alimentation de ces trois canaux.

Sur les figures des dessins annexés, en particulier sur les figures 2, 3A, 3B, 4, 5A, 5B et 5C, les signaux des différentes voies (H, X, Y) sont représentés avec des traits de natures différentes pour les distinguer mutuellement, en particulier au niveau des portions de ligne 3 et 3' (traits interrompus de types différents et traits continus à segments d'épaisseurs différentes alternativement).

Selon une première variante du mode de réalisation avantageux précité, non représentée sur les figures annexées (mais pouvant être déduite de la figure 1A), le circuit d'alimentation primaire 16, 16' propre à chaque circuit oscillant supplémentaire 12, 12' est partiellement confondu avec le circuit oscillant supplémentaire associé en intégrant une partie de circuit commune avec ce circuit oscillant supplémentaire, et comprend, d'une part, un générateur radiofréquence ajusté à la fréquence de résonance déterminée dudit circuit oscillant supplémentaire concerné et relié à ce dernier au niveau d'une borne du circuit ou composant d'accord symétrique réglable de ce circuit oscillant supplémentaire par l'intermédiaire d'une capacité de couplage et, d'autre part, un circuit ou composant d'adaptation relié à l'autre borne du circuit ou composant d'accord symétrique réglable précité, le composant d'adaptation et le composant d'accord symétrique réglable précités faisant partie des deux circuits, consistant en des capacités.

Selon une seconde variante du mode de réalisation avantageux, ressortant des figures 2, 3A, 3B, 4, 5A, 5B et 5C, le circuit séparé d'alimentation primaire 16 ; 16' propre à chaque circuit oscillant supplémentaire 12 ; 12' comprend, en plus d'un générateur radiofréquence 17 ; 17' ajusté à la fréquence de résonance déterminée et du ou des éléments 18, 18' ; 19, 19' participant au couplage avec l'un au moins des conducteurs 13" ; 14" des portions de ligne additionnelles 13', 13" ; 14', 14", un circuit ou composant d'adaptation 20 ; 20', destiné à optimiser le couplage et à en limiter certains effets au niveau dudit circuit d'alimentation primaire propre 16 ; 16', le générateur 17, 17' fonctionnant de manière continue, par intermittence ou de manière pulsée.

Préférentiellement, le couplage à transfert d'énergie entre le ou chaque circuit oscillant supplémentaire 12 ; 12' et son circuit d'alimentation primaire propre ou respectivement associé 16 ; 16' consiste en un couplage essentiellement magnétique et le circuit ou composant d'adaptation 20 ; 20' est préférentiellement une capacité réglable destinée à annuler la réactance inductive au niveau du circuit d'alimentation primaire propre considéré 16 ; 16'.

De manière avantageuse, le transfert d'énergie par couplage entre le circuit d'alimentation primaire propre 16 ; 16' associé à un circuit oscillant supplémentaire 12 ; 12' et ce dernier consiste en un couplage double, avec éventuellement deux zones de couplage sensiblement identiques et affectant de manière symétrique et équivalente les conducteurs 13" ; 14" des portions de lignes de transmission additionnelles 13, 13' ; 14, 14', reliés aux portions de ligne de transmission 3, 3' du premier circuit oscillant 4.

Comme représenté sur les figures 2, 3A, 3B, 4, 5B et 5C, le ou chacun des deux couplage(s) réalisant le transfert d'énergie entre un circuit d'alimentation primaire 16 ;16' propre à un circuit oscillant supplémentaire 12 ; 12' et ce dernier consiste en un couplage magnétique entre, d'une part, un segment 21 ; 21' d'un conducteur 13" ; 14" d'une portion de ligne additionnelle 13, 13' ; 14, 14', relié à l'une des portions de ligne 3, 3' du premier circuit oscillant 4, et, d'autre part, un segment 18, 18' ; 19, 19' de la ligne reliant le générateur 17 ; 17' au composant d'adaptation 20 ; 20' dans le circuit d'alimentation primaire 16 ; 16' propre associé au circuit oscillant supplémentaire 12 ; 12' considéré, ces deux segments 21 ; 21' et 18, 18' ; 19, 19' de longueurs déterminées étant disposés parallèlement et à proximité l'un de l'autre et formant des lignes de Lecher.

En variante, et comme le montrent les figures 5A et 6, il peut être prévu que le couplage réalisant le transfert d'énergie entre le circuit d'alimentation primaire 16 ; 16' propre à un circuit oscillant supplémentaire 12 ; 12' et ce dernier consiste en un couplage magnéto-capacitif, symétrique ou asymétrique, entre, d'une part, un solénoïde 18 ; 19 monté en série dans ledit circuit d'alimentation primaire propre 16 , 16' et, d'autre part, un ensemble 24 ; 24' capacité/inductance(s) monté en série dans le circuit oscillant supplémentaire considéré 12 ; 12', ladite capacité pouvant correspondre au composant d'accord 6' ; 6" et les inductances pouvant comprendre deux inductances 25, 25' ; 26, 26' montées en série de part et d'autre de ladite capacité 6' ; 6", en faisant éventuellement partie chacune d'un circuit LC.

Comme le montrent les figures 5A et 6 des dessins annexés, les couplages magnéto-capacité [9, 11'] au niveau du premier circuit oscillant 4 et/ou les couplages magnéto-capacitifs [18, 24] et/ou [19, 24'] au niveau du ou des circuit(s) oscillant(s) supplémentaire(s) 12, 12' peuvent par exemple consister en une spire ou un solénoïde [9, 18, 19] dont la position par rapport aux ensembles respectifs [11', 24, 24'] d'arrangements série de capacité [6, 6', 6"] et d'inductances [15 et 15', 25 et 25', 26 et 26'] peut être variée pour faire varier le degré du couplage. Cette modification de position peut, par exemple, résulter d'un déplacement en rotation du solénoïde [9, 18, 19], d'un déplacement en translation ou analogue.

Afin d'éviter toute disymétrisation du premier circuit oscillant 4 et/ou d'un quelconque circuit oscillant supplémentaire 12, 12' par l'ajout ou le greffage d'un nouveau circuit oscillant supplémentaire 12, 12', les deux portions de ligne additionnelles 13 et 13' ; 14 et 14' faisant partie dudit au moins un ou de chaque circuit oscillant supplémentaire 12 ; 12' sont reliées, en accord avec une caractéristique avantageuse, respectivement aux portions de ligne 3 et 3' faisant partie du premier circuit oscillant 4 au niveau de points froids non interférents 27, 27' des conducteurs 5, 5 de ces dernières portions de ligne 3 et 3'.

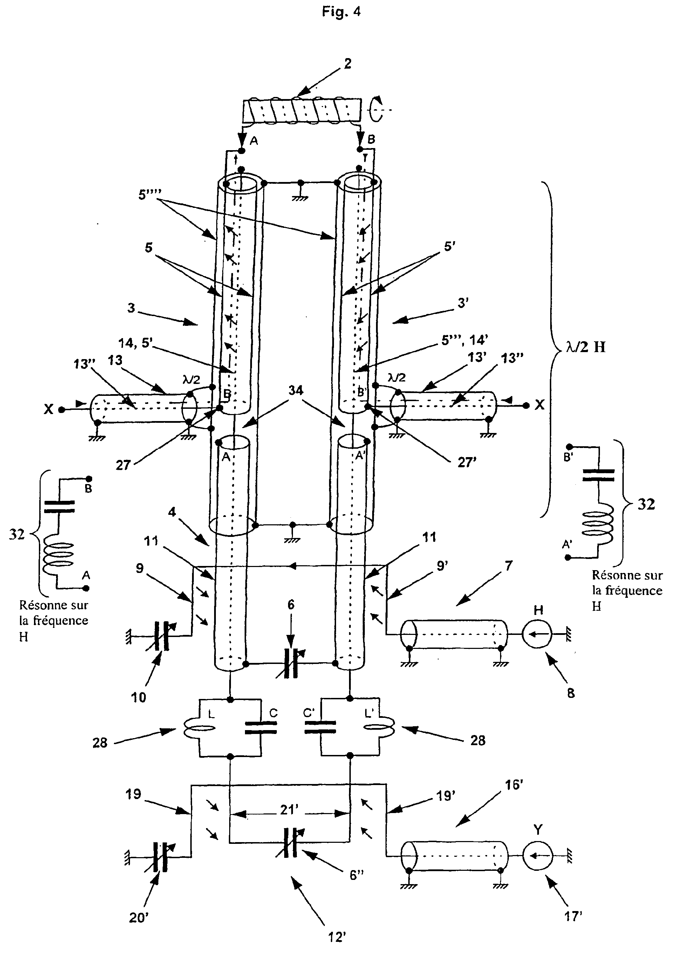

Dans certaines configurations de circuits 1, les deux portions de ligne additionnelles 13 et 13' ; 14 et 14' faisant partie dudit au moins un circuit oscillant supplémentaire 12 ; 12' sont reliées respectivement aux portions de ligne 3 et 3' faisant partie du premier circuit oscillant 4 au niveau des bornes du circuit ou composant d'accord 6 dudit premier circuit oscillant 4 (Fig. 4 et 5A).

Par "structure et constitution symétriques", appliquées aux circuits oscillants faisant partie du circuit d'alimentation 1, il y a lieu de comprendre dans la présente que chaque circuit oscillant présente électriquement, et donc également physiquement, une structure symétrique par rapport au centre de la bobine 2. Chaque circuit oscillant est bouclé, d'une part, sur cette bobine 2 et, d'autre part, sur un circuit ou composant d'accord symétrique réglable propre à ce circuit, par deux branches identiques.

En vue de limiter au maximum les influences entre les différentes voies d'alimentation 4, 12, 12', il peut être prévu que le premier circuit oscillant 4 et/ou le ou au moins l'un des circuit(s) oscillant(s) supplémentaire(s) 12 ; 12' intègre(nt) un ou des filtres d'isolation 28, 29 réjecteurs de bande ajusté(s), le cas échéant chacun, sur la fréquence de résonance de l'autre ou de l'un des autres circuit(s) oscillant(s) 4, 12 ou 12'.

Ces filtres d'isolation peuvent, par exemple, se présenter sous la forme de paire(s) de filtres 28 ou 29, chaque filtre d'une paire donnée de filtres 28, 29 étant relié en série à ou monté en série avec l'un des conducteurs 5, 5' reliés à la bobine 2 du premier circuit oscillant 4 ou à l'un des conducteurs 13" ; 14" des portions de lignes additionnelles 13, 13' ; 14, 14' du circuit oscillant supplémentaire 12 ou 12' considéré, relié à une ligne de transmission 3, 3' du premier circuit oscillant 4.

En outre, en présence d'un premier circuit oscillant 4 et de deux circuits oscillants supplémentaires 12 et 12', au moins l'un desdits circuits oscillants 4, 12, 12' intègre deux paires de filtres d'isolation 28 et 29, chaque paire de filtres 28, 29 étant ajustée sur la fréquence de résonance de l'un 4, 12 ou 12' des deux autres circuits oscillants 4, 12, 12', l'une des paires de filtres 29 au moins étant réglable en fréquence, préférentiellement de manière continue.

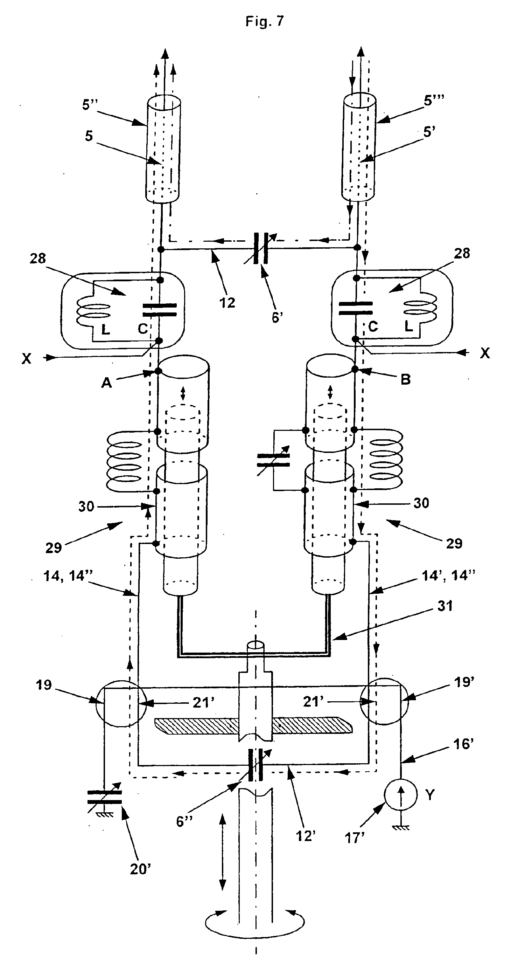

Avantageusement, et comme cela ressort des figures 7, 8A, 8B et 9 des dessins annexés, les filtres d'isolation 28, 29 consistent en des paires de circuits LC, la ou les paire(s) de filtres 29 éventuellement réglable(s) en fréquence intégrant des capacités 30 variables de manière continue avec un asservissement mécanique mutuel 31 de leur réglage.

Les capacités variables 30 peuvent par exemple consister en un élément mobile solidaire d'une des bornes de la capacité et un élément fixe solidaire de l'autre borne, les éléments mobiles des deux capacités 30 étant physiquement et/ou cinématiquement mutuellement reliés de manière à être déplacés simultanément de la même amplitude de mouvement. Le déplacement relatif des éléments mobiles par rapport aux éléments fixes variant la valeur de la capacitance des capacités variables 30.

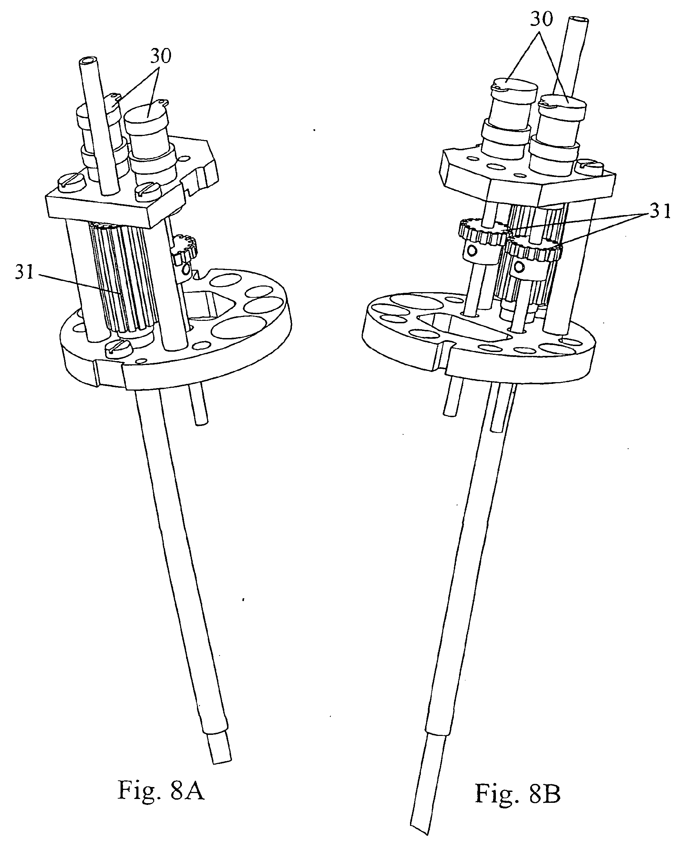

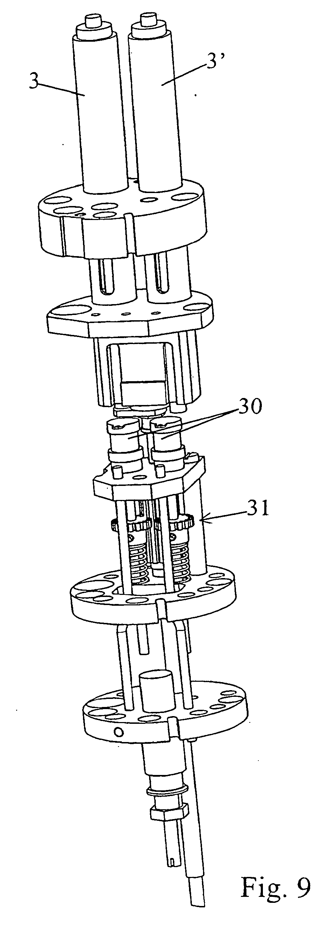

Ledit déplacement pourra consister en un mouvement de translation (Fig. 7), l'élément mobile formant ainsi un plongeur mobile dans le cylindre creux formé par l'élément fixe et les deux plongeurs étant reliés mécaniquement par une barre de connexion rigide solidaire d'un organe de déplacement (vis millimétrique par exemple). Le déplacement pourra également consister en une rotation (Fig. 8A, 8B et 9), les deux éléments mobiles étant alors montés sur des axes tournants pourvus de pignons dentés, lesquels sont entraînés de concert par un pignon menant solidaire d'une tige de commande.

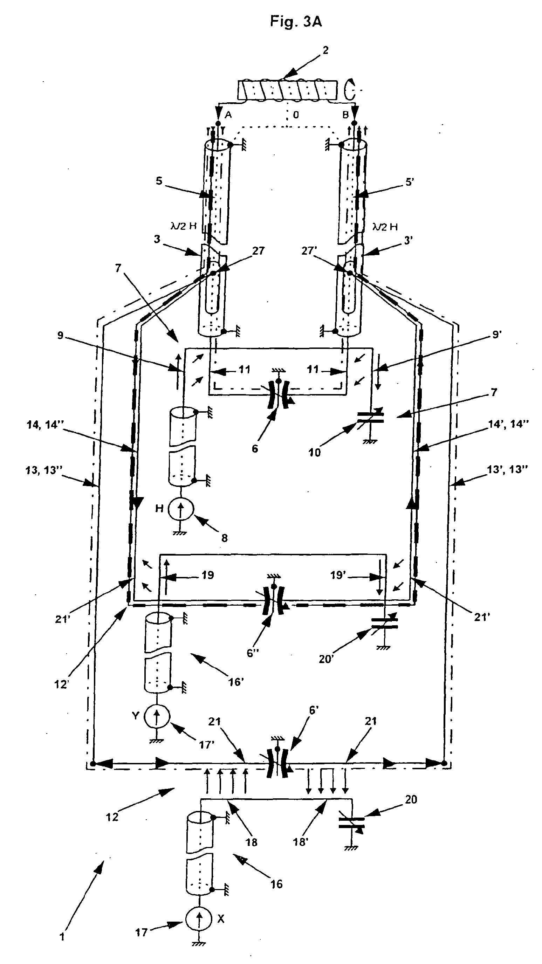

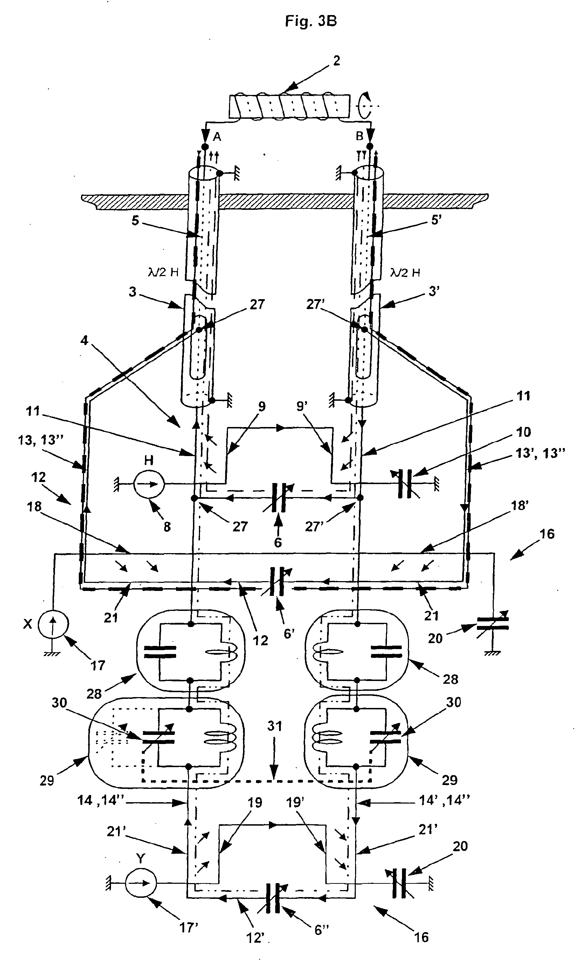

Comme cela ressort des figures 2, 3A et 3B, et en accord avec un mode de réalisation pratique de l'invention, les lignes de transmission 3 et 3' faisant partie du premier circuit oscillant 4 consistent en des lignes coaxiales, ainsi que préférentiellement les lignes de transmission additionnelles 13, 13' ; 14, 14'.

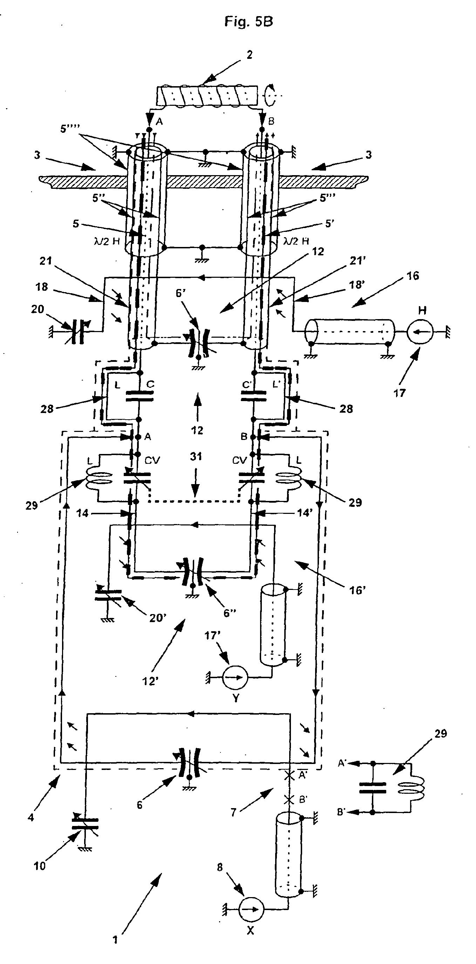

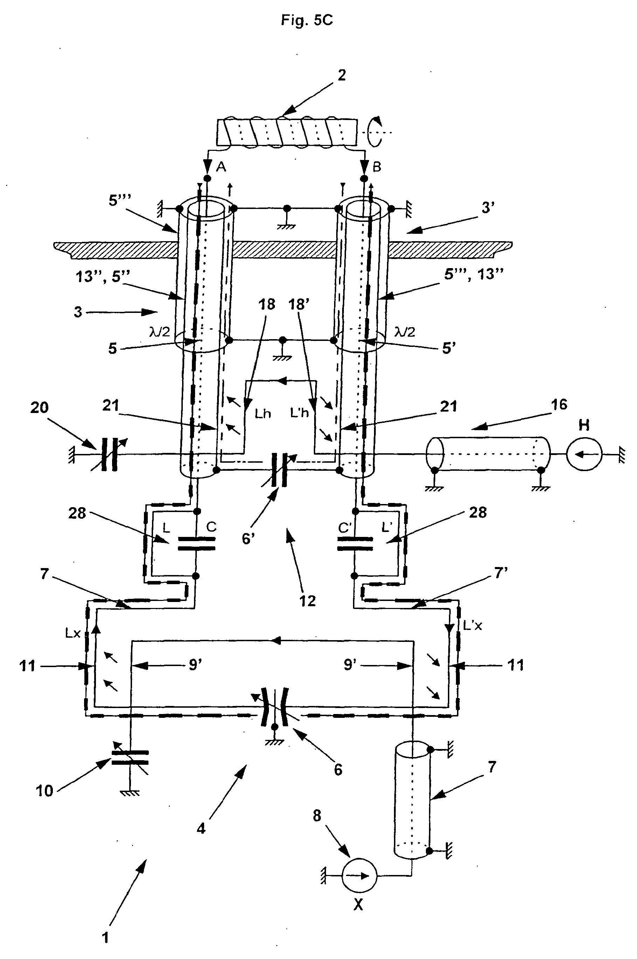

Comme cela ressort des figures 4, 5A, 5B et 5C, et en accord avec un autre mode de réalisation pratique de l'invention, les portions de lignes de transmission 3 et 3' faisant partie du premier circuit oscillant consistent en des portions de lignes triaxiales ou à trois conducteurs concentriques 5, 5", 5"" ; 5', 5''', 5"", au moins le premier circuit oscillant 4 intégrant les conducteurs 5 et 5' reliés directement à la bobine 2 desdites lignes triaxiales 3 et 3', et au moins un autre desdits circuits oscillants 12, 12' intégrant des conducteurs concentriques supplémentaires 5" et 5"' desdites lignes triaxiales 3 et 3', un transfert d'énergie s'effectuant entre ces conducteurs 5", 5"' et 5, 5' concentriques respectivement associés, du fait de la capacité linéique répartie desdites lignes triaxiales 3 et 3'.

Conformément à une première variante de configuration de cet autre mode de réalisation pratique précité, les conducteurs 5 et 5' des lignes triaxiales 3 et 3' reliés directement à la bobine 2 sont constitués par les conducteurs intermédiaires de ces dernières au moins un des circuits oscillants supplémentaires 12, 12' est relié aux et intègre les conducteurs centraux 5" et 5"' non reliés à la bobine 2, la capacité linéique répartie entre ces conducteurs centraux et intermédiaires fournissant une connexion par transfert d'énergie permettant audit circuit oscillant supplémentaire considéré 12, 12' de se boucler sur la bobine 2 par l'intermédiaire des conducteurs intermédiaires 5 et 5' (Figure 4).

Il peut, dans cette première variante, être prévu que les conducteurs intermédiaires 5 et 5' présentent chacun une coupure ou discontinuité physique 34 au niveau d'un point froid non interférent 27, 27' respectif et que les portions de lignes additionnelles 13, 13' ;14, 14' de l'un au moins des circuits oscillants supplémentaires 12, 12' sont reliées au niveau desdits points froids aux parties des conducteurs intermédiaires 5, 5' reliées à la bobine 2, les parties desdits conducteurs 5 et 5' en regard au niveau de ladite coupure ou discontinuité 34 étant reliées entre elles par des circuits de transfert d'énergie 32 sélectifs en fréquence, par exemple des filtres passe-bandes centrés sur la fréquence de résonance du premier circuit oscillant 4 et transmettant le maximum d'énergie pour cette fréquence.

Conformément à une seconde variante de configuration de cet autre mode de réalisation pratique précité, les conducteurs 5 et 5' reliés directement à la bobine 2 des lignes triaxiales 3 et 3' sont constitués par les conducteurs centraux de ces dernières et au moins un des circuits oscillants supplémentaires 12 intègre les conducteurs intermédiaires 5" et 5"' non reliés à la bobine 2, la capacité linéique répartie entre ces conducteurs centraux et intermédiaires fournissant une connexion par transfert d'énergie permettant audit circuit oscillant supplémentaire considéré 12, 12' de se boucler sur la bobine 2 par l'intermédiaire des conducteurs centraux 5 et 5' (Figures 5A, 5B et 5C).

Il peut dans cette seconde variante être prévu que les conducteurs 13" ; 14" des portions de lignes additionnelles 13, 13' ; 14, 14' d'au moins un autre circuit oscillant supplémentaire 12' soient reliés aux conducteurs centraux 5 et 5' au niveau de points froids non interférents 27, 27' de ces conducteurs, que des filtres réjecteurs 29 isolent entre eux le premier circuit oscillant 4 et le ou les circuit(s) oscillant(s) supplémentaire(s) 12' dont les conducteurs 13", 14" sont reliés auxdits conducteurs centraux 5 et 5' et que ces derniers circuits oscillants 4 et 12' soient également, ensemble, isolés dudit au moins un circuit oscillant supplémentaire 12 intégrant les conducteurs intermédiaires 5" et 5"' non reliés à la bobine 2, par des filtres réjecteurs 28.

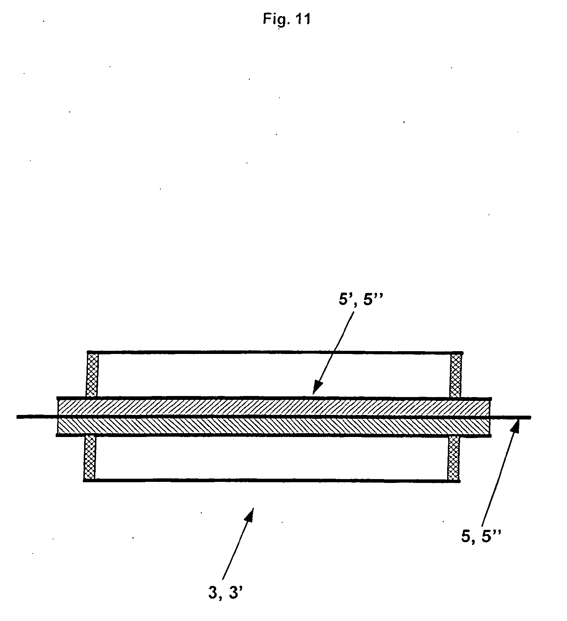

A titre d'exemple, comme le montre la figure 11, chaque portion de ligne 3, 3' triaxiale peut être constituée par exemple par un câble coaxial monté soit dans un tube métallique (formant le conducteur externe), soit en lieu et place du conducteur central d'un câble coaxial de plus grand diamètre.

Grâce à l'invention, il est donc possible de fournir une alimentation avec un maximum d'intensité toujours situé exactement au milieu de la bobine 2, ce quelle que soit la fréquence d'excitation concernée.

En outre, l'ajout d'un circuit oscillant supplémentaire (à structure symétrique), associé à une fréquence de résonance correspondante, n'a sensiblement aucune influence sur les circuits oscillants faisant déjà partie du circuit d'alimentation, et en particulier n'entraîne aucune dissymétrie dans ces circuits existants.

Par ailleurs, les portions de ligne de transmission 3 et 3' utilisées par tous les circuits oscillants 4, 12, 12' (et au moins en partie communes à ces derniers), ne sont pas modifiées et ne font l'objet d'aucune opération de réglage, même lors du rajout d'un nouveau circuit oscillant.

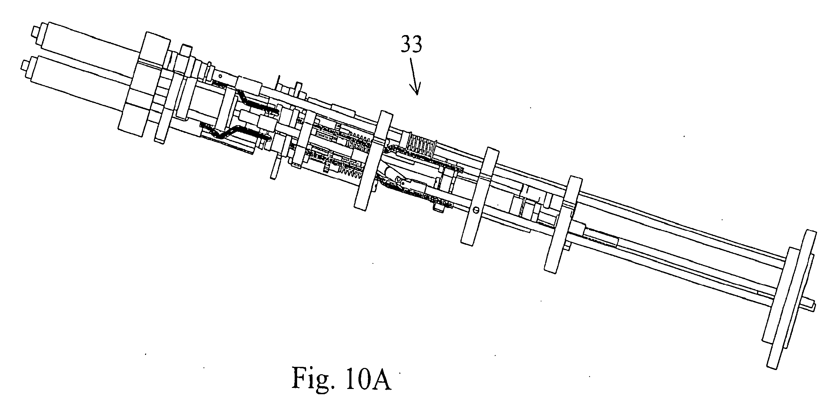

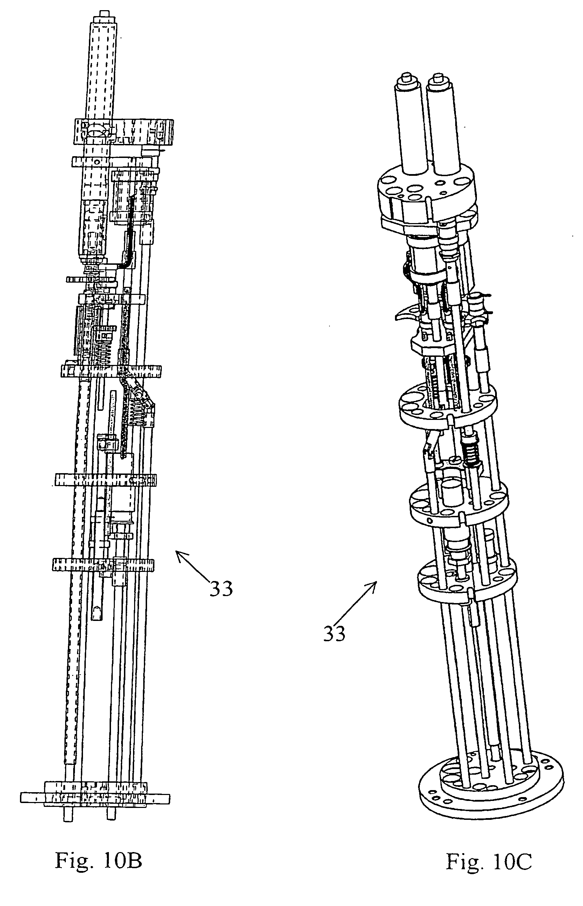

L'invention a également pour objet une sonde RMN 33 multifréquence, caractérisée en ce qu'elle comprend, au moins en partie, un circuit d'alimentation 1 de la bobine d'échantillon présentant au moins certaines des caractéristiques exposées ci-dessus (voir figures 8A, 8B, 9, 10A, 10B et 10C).

Enfin, l'invention couvre également un spectromètre RMN, en particulier pour spectrométrie en phase solide, caractérisé en ce qu'il comprend un circuit d'alimentation 1 de la bobine d'échantillon 2 tel que décrit ci-dessus et une sonde du type mentionné précédemment.

Bien entendu, l'invention qui est définie dans les revendications n'est pas limitée au mode de réalisation décrit et représenté aux dessins annexés.

## Revendications

1. Circuit d'alimentation d'une bobine HF ou bobine d'échantillon d'un appareil de RMN, comprenant deux portions de ligne de transmission reliées chacune à l'une des deux extrémités de cette bobine, lesdites portions de ligne formant avec ladite bobine un premier circuit oscillant (4) présentant une fréquence de résonance déterminée, les deux portions de ligne (3, 3') comportant chacune au moins deux conducteurs (5, 5' ; 5", 5"'), dont l'un (5, 5') est relié à la bobine (2), et présentant entre elles des structures identiques et des longueurs de conducteurs reliés identiques,
**caractérisé**
**en ce que** chacune de ces longueurs identiques est sensiblement un multiple de la moitié de la longueur d'onde de résonance dudit circuit oscillant (4),
**en ce que** les conducteurs (5, 5') reliés à la bobine (2) à l'une de leurs extrémités sont reliés entre eux à leur autre extrémité par un circuit ou composant d'accord symétrique réglable (6) complétant ce circuit oscillant (4),
et **en ce que** ledit circuit oscillant (4) à structure symétrique est alimenté par un circuit d'alimentation primaire (7) par l'intermédiaire d'un transfert d'énergie par couplage magnétique, capacitif ou magnéto-capacitif dudit circuit d'alimentation primaire (7) avec les deux conducteurs (5, 5') reliés à la bobine (2) et au circuit ou composant d'accord (6).

2. Circuit d'alimentation selon la revendication 1, **caractérisé en ce que** le circuit d'alimentation primaire (7) est partiellement confondu avec le premier circuit oscillant (4), en intégrant une partie de circuit (7') commune avec ce premier circuit oscillant, et **en ce qu'**il comprend, d'une part, un générateur radiofréquence (8) ajusté à la fréquence de résonance déterminée du premier circuit oscillant (4) et relié audit premier circuit oscillant (4) au niveau d'une borne du circuit ou composant d'accord symétrique réglable (6) par l'intermédiaire d'une capacité de couplage (8') et, d'autre part, un circuit ou composant d'adaptation (10) relié à l'autre borne du circuit ou composant d'accord symétrique réglable (6), le composant d'adaptation (10) et le composant d'accord symétrique réglable (6) faisant partie des deux circuits (4 et 7), consistant en des capacités et le générateur (8) fonctionnant de manière continue, par intermittence ou de manière pulsée.

3. Circuit d'alimentation selon la revendication 1, **caractérisé en ce que** le circuit d'alimentation primaire (7) consiste en un circuit séparé et comprend, en plus d'un générateur radiofréquence (8) ajusté à la fréquence de résonance déterminée et d ou des éléments (9, 9') participant au couplage avec les deux conducteurs (5, 5') d'une ou des portions de ligne (3, 3') relié à la bobine (2) et au circuit ou composant d'accord (6), également un circuit ou composant d'adaptation (10), destiné à optimiser le couplage et à en limiter certains effets au niveau du circuit d'alimentation primaire (7), le générateur (8) fonctionnant de manière continue, par intermittence ou de manière pulsée.

4. Circuit d'alimentation selon l'une quelconque des revendications 1 et 3, **caractérisé en ce que** le couplage est un couplage essentiellement de nature magnétique et **en ce que** le circuit ou composant d'adaptation (10) est une capacité réglable destinée à annuler la réactance inductive au niveau du circuit d'alimentation primaire (7).

5. Circuit d'alimentation selon l'une quelconque des revendications 1, 3 et 4, **caractérisé en ce que** le transfert d'énergie par couplage entre le circuit d'alimentation primaire (7) et le circuit oscillant (4) consiste en un couplage double et affecte de manière symétrique et équivalente les conducteurs (5 et 5' ; 5", 5"') reliés à la bobine (2) des deux portions de ligne de transmission (3 et 3').

6. Circuit d'alimentation selon l'une quelconque des revendications 4 et 5, pour autant qu'elles dépendent de la revendication 3, **caractérisé en ce que** le ou chacun des deux couplage(s) réalisant le transfert d'énergie consiste en un couplage principalement magnétique entre, d'une part, un segment (11) d'un conducteur (5, 5') relié à la bobine (2) d'une des portions de ligne (3, 3') du circuit oscillant (4) et, d'autre part, un segment (9, 9') de la ligne reliant le générateur (8) au composant d'adaptation (10) dans le circuit d'alimentation primaire (7), ces deux segments (11 et 9, 9') de longueurs déterminées étant disposés parallèlement et à proximité l'un de l'autre et formant des lignes de Lecher.

7. Circuit d'alimentation selon l'une quelconque des revendications 4 et 5, pour autant qu'elles dépendent de la revendication 3, **caractérisé en ce que** le couplage réalisant le transfert d'énergie consiste en un couplage magnéto-capacitif, symétrique ou asymétrique, entre, d'une part, un solénoïde (9) monté en série dans le circuit d'alimentation primaire (7) et, d'autre part, un ensemble (11') capacité/inductance(s) monté en série dans le circuit oscillant (4), ladite capacité pouvant correspondre au composant d'accord (6) et les inductances comprendre deux inductances équivalentes (15, 15') montées en série de part et d'autre de ladite capacité (6), en faisant éventuellement partie chacune d'un circuit LC.

8. Circuit d'alimentation selon l'une quelconque des revendications 1 à 7, **caractérisé en ce qu'**il comprend au moins un circuit oscillant supplémentaire (12, 12') présentant une fréquence de résonance différente de celle du premier circuit oscillant (4) et formé, le cas échéant chacun, par la bobine (2), des parties mutuellement équivalentes d'un conducteur (5, 5', 5", 5"') des deux portions de ligne (3, 3') du premier circuit oscillant (4) et, éventuellement, deux portions de ligne de transmission additionnelles (13, 13' ; 14, 14') reliées chacune par l'une des extrémités de leur au moins un conducteur (13", 14") respectif à l'un des conducteurs (5, 5" ; 5', 5"') de l'une des deux portions de ligne (3, 3') précitées et présentant entre elles des structures et des longueurs identiques, **en ce que** la somme de la longueur de chacune desdites deux portions de lignes de transmission additionnelles (13, 13' ; 14, 14') et de la longueur de la partie de conducteur (5, 5' ; 5", 5"') respectivement associée de l'une des deux portions de ligne (3, 3') est un multiple de la demi-longueur d'onde de résonance du circuit oscillant supplémentaire considéré (12, 12'), **en ce que** les lignes de transmission additionnelles (13, 13' ; 14, 14') sont reliées à leur autre extrémité à un circuit ou composant d'accord (6', 6") et **en ce que** ledit au moins un ou chaque circuit oscillant supplémentaire (12, 12') est alimenté par un circuit d'alimentation primaire (16, 16') propre correspondant, ce par l'intermédiaire d'un transfert d'énergie par couplage magnétique, capacitif ou magnéto-capacitif de ce circuit d'alimentation primaire (16, 16') respectif correspondant avec au moins un des conducteurs (13" ; 14") reliés aux ou faisant partie des portions de ligne (3, 3') du premier circuit oscillant (4), d'au moins une des deux portions de ligne de transmission additionnelles (13, 13' ; 14, 14').

9. Circuit d'alimentation selon la revendication 8, **caractérisé en ce que** le circuit d'alimentation primaire (16, 16') propre à chaque circuit oscillant supplémentaire (12, 12') est partiellement confondu avec le circuit oscillant supplémentaire associé en intégrant une partie de circuit commune avec ce circuit oscillant supplémentaire, et **en ce qu'**il comprend, d'une part, un générateur radiofréquence ajusté à la fréquence de résonance déterminée dudit circuit oscillant supplémentaire concerné et relié à ce dernier au niveau d'une borne du circuit ou composant d'accord symétrique réglable de ce circuit oscillant supplémentaire par l'intermédiaire d'une capacité de couplage et, d'autre part, un circuit ou composant d'adaptation relié à l'autre borne du circuit ou composant d'accord symétrique réglable précité, le composant d'adaptation et le composant d'accord symétrique réglable précités faisant partie des deux circuits, consistant en des capacités.

10. Circuit d'alimentation selon la revendication 8, **caractérisé en ce que** le circuit d'alimentation primaire (16 ; 16') propre à chaque circuit oscillant supplémentaire (12 ; 12') comprend, en plus d'un générateur radiofréquence (17 ; 17') ajusté à la fréquence de résonance déterminée et du ou des éléments (18, 18' ; 19, 19') participant au couplage avec l'un au moins des conducteurs (13" ; 14") des portions de ligne additionnelles (13', 13" ; 14', 14"), un circuit ou composant d'adaptation (20 ; 20'), destiné à optimiser le couplage et à en limiter certains effets au niveau dudit circuit d'alimentation primaire propre (16 ; 16'), le générateur (17, 17') fonctionnant de manière continue, par intermittence ou de manière pulsée.

11. Circuit d'alimentation selon l'une quelconque des revendications 8 et 10, **caractérisé en ce que** le couplage à transfert d'énergie entre le ou chaque circuit oscillant supplémentaire (12 ; 12') et son circuit d'alimentation primaire propre ou respectivement associé (16 ; 16') consiste en un couplage essentiellement magnétique et **en ce que** le circuit ou composant d'adaptation (20 ; 20') est une capacité réglable destinée à annuler la réactance inductive au niveau du circuit d'alimentation primaire propre considéré (16 ; 16').

12. Circuit d'alimentation selon l'une quelconque des revendications 8, 10 et 11, **caractérisé en ce que** le transfert d'énergie par couplage entre le circuit d'alimentation primaire propre (16 ; 16') associé à un circuit oscillant supplémentaire (12 ; 12') et ce dernier consiste en un couplage double, avec éventuellement deux zones de couplage sensiblement identiques et affectant de manière symétrique et équivalente les conducteurs (13" ; 14") des portions de lignes de transmission additionnelles (13, 13' ; 14, 14'), reliés aux portions de ligne de transmission (3, 3') du premier circuit oscillant (4).

13. Circuit d'alimentation selon l'une quelconque des revendications 11 et 12, pour autant qu'elles se rattachent à la revendication 10, **caractérisé en ce que** le ou chacun des deux couplage(s) réalisant le transfert d'énergie entre un circuit d'alimentation primaire (16 ;16') propre à un circuit oscillant supplémentaire (12 ; 12') et ce dernier consiste en un couplage magnétique entre, d'une part, un segment (21 ; 21') d'un conducteur (13" ; 14") d'une portion de ligne additionnelle (13, 13' ; 14, 14'), relié à l'une des portions de ligne (3, 3') du premier circuit oscillant (4), et, d'autre part, un segment (18, 18' ; 19, 19') de la ligne reliant le générateur (17 ; 17') au composant d'adaptation (20 ; 20') dans le circuit d'alimentation primaire (16 ; 16') propre associé au circuit oscillant supplémentaire (12 ; 12') considéré, ces deux segments (21 ; 21' et 18, 18' ; 19, 19') de longueurs déterminées étant disposés parallèlement et à proximité l'un de l'autre et formant des lignes de Lecher.

14. Circuit d'alimentation selon l'une quelconque des revendications 11 et 12, pour autant qu'elles se rattachent à la revendication 10, **caractérisé en ce que** le couplage réalisant le transfert d'énergie entre le circuit d'alimentation primaire (16 ; 16') propre à un circuit oscillant supplémentaire (12 ; 12') et ce dernier consiste en un couplage magnéto-capacitif, symétrique ou asymétrique, entre, d'une part, un solénoïde (18 ; 19) monté en série dans ledit circuit d'alimentation primaire propre (16 , 16') et, d'autre part, un ensemble (24 ; 24') capacité/inductance(s) monté en série dans le circuit oscillant supplémentaire considéré (12 ; 12'), ladite capacité pouvant correspondre au composant d'accord (6' ; 6") et les inductances pouvant comprendre deux inductances (25, 25' ; 26, 26') montées en série de part et d'autre de ladite capacité (6' ; 6"), en faisant éventuellement partie chacune d'un circuit LC.

15. Circuit d'alimentation selon l'une quelconque des revendications 1 à 14, **caractérisé en ce que** les deux portions de ligne additionnelles (13 et 13' ; 14 et 14') faisant partie dudit au moins un ou de chaque circuit oscillant supplémentaire (12 ; 12') sont reliées respectivement aux portions de ligne (3 et 3') faisant partie du premier circuit oscillant (4) au niveau de points froids non interférants (27, 27') des conducteurs (5, 5') de ces dernières portions de ligne (3 et 3').

16. Circuit d'alimentation selon l'une quelconque des revendications 8 à 14, **caractérisé en ce que** les deux portions de ligne additionnelles (13 et 13' ; 14 et 14') faisant partie dudit au moins un circuit oscillant supplémentaire (12 ; 12') sont reliées respectivement aux portions de ligne (3 et 3') faisant partie du premier circuit oscillant (4) au niveau des bornes du circuit ou composant d'accord (6) dudit premier circuit oscillant (4).

17. Circuit d'alimentation selon l'une quelconque des revendications 8 à 16, **caractérisé en ce que** le premier circuit oscillant (4) et/ou le ou au moins l'un des circuit(s) oscillant(s) supplémentaire(s) (12 ; 12') intègre(nt) un ou des filtres d'isolation (28, 29) réjecteurs de bande ajusté(s), le cas échéant chacun, sur la fréquence de résonance de l'autre ou de l'un des autres circuit(s) oscillant(s) (4, 12 ou 12').

18. Circuit d'isolation selon la revendication 17, **caractérisé en ce que** les filtres d'isolation (28, 29) se présentent sous la forme de paire(s) de filtres (28 ou 29), chaque filtre d'une paire donnée de filtres (28, 29) étant relié en série à ou monté en série avec l'un des conducteurs (5, 5') reliés à la bobine (2) du premier circuit oscillant (4) ou à l'un des conducteurs (13" ; 14") des portions de lignes additionnelles (13, 13' ; 14, 14') du circuit oscillant supplémentaire (12 ou 12') considéré, relié à une ligne de transmission (3, 3') du premier circuit oscillant (4).

19. Circuit d'alimentation selon la revendication 17 ou 18, **caractérisé en ce que** en présence d'un premier circuit oscillant (4) et de deux circuits oscillants supplémentaires (12 et 12'), au moins l'un desdits circuits oscillants (4, 12, 12') intègre deux paires de filtres d'isolation (28 et 29), chaque paire de filtres (28, 29) étant ajustée sur la fréquence de résonance de l'un (4, 12 ou 12') des deux autres circuits oscillants (4, 12, 12'), l'une des paires de filtres (29) au moins étant réglable en fréquence, préférentiellement de manière continue.

20. Circuit d'alimentation selon l'une quelconque des revendications 17 et 18, **caractérisé en ce que** les filtres d'isolation (28, 29) consistent en des paires de circuits LC, la ou les paire(s) de filtres (29) éventuellement réglable(s) en fréquence intégrant des capacités (30) variables de manière continue avec un asservissement mécanique mutuel (31) de leur réglage.

21. Circuit d'alimentation selon l'une quelconque des revendications 8 à 20, **caractérisé en ce que** les lignes de transmission (3 et 3') faisant partie du premier circuit oscillant (4) consistent en des lignes coaxiales, ainsi que préférentiellement les lignes de transmission additionnelles (13, 13' ; 14, 14').

22. Circuit d'alimentation selon l'une quelconque des revendications 8 à 20, **caractérisé en ce que** les portions de lignes de transmission (3 et 3') faisant partie du premier circuit oscillant consistent en des portions de lignes triaxiales ou à trois conducteurs concentriques (5, 5", 5"" ; 5', 5"', 5""), au moins le premier circuit oscillant (4) intégrant les conducteurs (5 et 5') reliés directement à la bobine (2) desdites lignes triaxiales (3 et 3'), et au moins un autre desdits circuits oscillants (12, 12') intégrant des conducteurs concentriques supplémentaires (5" et 5"') desdites lignes triaxiales (3 et 3'), un transfert d'énergie s'effectuant entre ces conducteurs (5", 5"' et 5, 5') concentriques respectivement associés, du fait de la capacité linéique répartie desdites lignes triaxiales (3 et 3').

23. Circuit d'alimentation selon la revendication 22, **caractérisé en ce que** les conducteurs (5 et 5') reliés directement à la bobine (2) des lignes triaxiales (3 et 3') sont constitués par les conducteurs intermédiaires de ces dernières et **en ce qu'**au moins un des circuits oscillants supplémentaires (12, 12') est relié aux et intègre les conducteurs centraux (5" et 5"') non reliés à la bobine (2), la capacité linéique répartie entre ces conducteurs centraux et intermédiaires fournissant une connexion par transfert d'énergie permettant audit circuit oscillant supplémentaire considéré (12, 12') de se boucler sur la bobine (2) par l'intermédiaire des conducteurs intermédiaires (5 et 5').

24. Circuit d'alimentation selon la revendication 23, **caractérisé en ce que** les conducteurs intermédiaires (5 et 5') présentent chacun une coupure ou discontinuité physique (34) au niveau d'un point froid non interférent (27, 27') respectif et **en ce que** les portions de lignes additionnelles (13, 13' ;14, 14') de l'un au moins des circuits oscillants supplémentaires (12, 12') sont reliées au niveau desdits points froids aux parties des conducteurs intermédiaires (5, 5') reliées à la bobine (2), les parties desdits conducteurs (5 et 5') en regard au niveau de ladite coupure ou discontinuité (34) étant reliées entre elles par des circuits de transfert d'énergie (32) sélectifs en fréquence, par exemple des filtres passe-bandes centrés sur la fréquence de résonance du premier circuit oscillant (4) et transmettant le maximum d'énergie pour cette fréquence.

25. Circuit d'alimentation selon la revendication 22, **caractérisé en ce que** les conducteurs (5 et 5') reliés directement à la bobine (2) des lignes triaxiales (3 et 3') sont constitués par les conducteurs centraux de ces dernières et **en ce qu'**au moins un des circuits oscillants supplémentaires (12) intègre les conducteurs intermédiaires (5" et 5"') non reliés à la bobine (2), la capacité linéique répartie entre ces conducteurs centraux et intermédiaires fournissant une connexion par transfert d'énergie permettant audit circuit oscillant supplémentaire considéré (12, 12') de se boucler sur la bobine (2) par l'intermédiaire des conducteurs centraux (5 et 5').

26. Circuit d'alimentation selon la revendication 25, **caractérisé en ce que** les conducteurs (13" ; 14") des portions de lignes additionnelles (13, 13' ; 14, 14') d'au moins un autre circuit oscillant supplémentaire (12') sont reliés aux conducteurs centraux (5 et 5') au niveau de points froids non interférents (27, 27') de ces conducteurs, **en ce que** des filtres réjecteurs (29) isolent entre eux le premier circuit oscillant (4) et le ou les circuit(s) oscillant(s) supplémentaire(s) (12') dont les conducteurs (13", 14") sont reliés auxdits conducteurs centraux (5 et 5') et **en ce que** ces derniers circuits oscillants (4 et 12') sont également, ensemble, isolés dudit au moins un circuit oscillant supplémentaire (12) intégrant les conducteurs intermédiaires (5" et 5"') non reliés à la bobine (2), par des filtres réjecteurs (28).

27. Sonde RMN, **caractérisée en ce qu'**elle est pourvue d'un circuit d'alimentation (1) de la bobine d'échantillon (2) selon l'une quelconque des revendications 1 à 26.

28. Spectromètre RMN, en particulier pour spectrométrie en phase solide, **caractérisé en ce qu'**il comprend un circuit d'alimentation (1) de la bobine d'échantillon (2) selon l'une quelconque des revendications 1 à 26.

## Claims

1. Power supply circuit of an RF coil or NMR machine sample coil, comprising two transmission line portions each connected to one of the two ends of this coil, said line portions forming with said coil a first oscillatory circuit (4) having a particular resonant frequency, the two line portions (3, 3') each including at least two conductors (5, 5'; 5", 5"'), of which one conductor (5, 5') is connected to the coil (2), and having identical structures and identical connected conductor lengths, **characterised in that:**
each of these identical lengths is substantially a multiple of half the resonant wavelength of said oscillatory circuit (4),
the conductors (5, 5') connected to the coil (2) at one of their ends are connected together at their other end by a tunable symmetrical tuning circuit or component (6) completing this oscillatory circuit (4), and
said symmetrical structure oscillatory circuit (4) is supplied with power by a primary power supply circuit (7) by energy transfer by magnetic, capacitive or magneto-capacitive coupling of said primary power supply circuit (7) and the two conductors (5, 5') connected to the coil (2) and to the tuning circuit or component (6).

2. Power supply circuit according to claim 1, **characterised in that** the primary power supply circuit (7) is partially combined with the first oscillatory circuit (4) by incorporating a circuit portion (7') common to that first oscillatory circuit and **in that** it includes, on the one hand, a radio-frequency generator (8) tuned to the particular resonant frequency of the first oscillatory circuit (4) and connected to said first oscillatory circuit (4) at a terminal of the tunable symmetrical tuning circuit or component (6) via a coupling capacitor (8') and, on the other hand, a matching circuit or component (10) connected to the other terminal of the tunable symmetrical tuning circuit or component (6), the matching component (10) and the tunable symmetrical tuning component (6) forming part of two circuits (4 and 7), consisting of capacitors and the generator (8) operating continuously, intermittently or in a pulsed manner.

3. Power supply circuit according to claim 1, **characterised in that** the primary power supply circuit (7) consists of a separate circuit and includes, in addition to a radio-frequency generator (8) tuned to the particular resonant frequency and the component or components (9, 9') participating in the coupling with the two conductors (5, 5') of a line portion or line portions (3, 3') connected to the coil (2) and to the tuning circuit or component (6), a matching circuit or component (10) intended to optimise the coupling and to limit certain effects thereof on the primary power supply circuit (7), the generator (8) operating continuously, intermittently or in a pulsed manner.

4. Power supply circuit according to either of claims 1 and 3, **characterised in that** the coupling is essentially magnetic and **in that** the matching circuit or component (10) is a variable capacitor intended to cancel out the inductive reactance in the primary power supply circuit (7).

5. Power supply circuit according to any one of claims 1, 3 and 4, **characterised in that** the energy transfer by coupling between the primary power supply circuit (7) and the oscillatory circuit (4) is a double coupling and affects symmetrically and in an equivalent manner the conductors (5 and 5'; 5", 5"') connected to the coil (2) of the two transmission line portions (3 and 3').

6. Power supply circuit according to either of claims 4 and 5, when dependent on claim 3, **characterised in that** the coupling or each coupling of the double coupling producing the energy transfer is a primarily magnetic coupling between, on the one hand, a segment (11) of a conductor (5, 5') connected to the coil (2) of one of the line portions (3, 3') of the oscillatory circuit (4) and, on the other hand, a segment (9, 9') of the line connecting the generator (8) to the matching component (10) in the primary power supply circuit (7), these two segments (11 and 9, 9') of particular length being disposed parallel to and near each other and forming Lecher lines.

7. Power supply circuit according to either of claims 4 and 5, when dependent on claim 3, **characterised in that** the coupling producing the energy transfer is symmetrical or asymmetrical magneto-capacitive coupling between, on the one hand, a solenoid (9) connected in series in the primary power supply circuit (7) and, on the other hand, a combination (11') of a capacitor and inductor(s) connected in series in the oscillatory circuit (4), which capacitor can correspond to the tuning component (6) and which inductor(s) can comprise two equivalent inductors (15, 15') connected in series on either side of said capacitor (6), each where applicable forming part of an LC circuit.

8. Power supply circuit according to any one of claims 1 to 7, **characterised in that** it includes at least one additional oscillatory circuit (12, 12') having a resonant frequency different from that of the first oscillatory circuit (4) and formed, where applicable each formed, by the coil (2), mutually equivalent portions of a conductor (5, 5', 5", 5"') of the two line portions (3, 3') of the first oscillatory circuit (4) and, where applicable, two additional transmission line portions (13, 13'; 14, 14') each connected by one end of their respective at least one conductor (13", 14") to one of the conductors (5, 5"; 5', 5"') of one of the two aforementioned line portions (3, 3') and having identical structures and lengths, **in that** the sum of the lengths of said additional transmission line portions (13, 13'; 14, 14') and the lengths of the conductor portion (5, 5'; 5", 5"') respectively associated with one of the two line portions (3, 3') is a multiple of half the resonant wavelength of the additional oscillatory circuit (12, 12') concerned, **in that** the additional transmission lines (13, 13'; 14, 14') are connected at their other end to a tuning circuit or component (6', 6") and **in that** said at least one or each additional oscillatory circuit (12, 12') is supplied with power by a corresponding primary power supply circuit (16, 16') of its own by a transfer of energy by magnetic, capacitive or magneto-capacitive coupling of the corresponding respective primary power supply circuit (16, 16') and at least one of the conductors (13"; 14") connected to or forming part of the line portions (3, 3') of the first oscillatory circuit (4), of at least one of the two additional transmission line portions (13, 13'; 14, 14').

9. Power supply circuit according to claim 8, **characterised in that** the primary power supply circuit (16, 16') specific to each additional oscillatory circuit (12, 12') is partially combined with the associated additional oscillatory circuit by incorporating a circuit portion common to that additional oscillatory circuit and **in that** it includes, on the one hand, a radio-frequency generator tuned to the particular resonant frequency of said additional oscillatory circuit concerned and connected thereto at a terminal of the tunable symmetrical tuning circuit or component of the additional oscillatory circuit via a coupling capacitor and, on the other hand, a matching circuit or component connected to the other terminal of the aforementioned tunable symmetrical tuning circuit or component, the aforementioned matching component and tunable symmetrical tuning component being part of the two circuits and consisting of capacitors.

10. Power supply circuit according to claim 8, **characterised in that** the primary power supply circuit (16, 16') specific to each additional oscillatory circuit (12, 12') includes, in addition to a radio-frequency generator tuned to the particular resonant frequency and the element or elements (18, 18'; 19, 19') participating in the coupling with at least one of the conductors (13"; 14") of the additional line portions (13', 13"; 14', 14"), a matching circuit or component (20; 20') intended to optimise the coupling and to limit certain effects thereof on said specific primary power supply circuit (16; 16'), the generator (17, 17') operating continuously, intermittently or in a pulsed manner.

11. Power supply circuit according to either of claims 8 and 10, **characterised in that** the energy transfer coupling between the or each additional oscillatory circuit (12, 12') and its own primary power supply circuit or respectively associated primary power supply circuit (16; 16') is essentially magnetic coupling and **in that** the matching circuit or component (20; 20') is a variable capacitor intended to cancel out the inductive reactance in the specific primary power supply circuit (16; 16') concerned.

12. Power supply circuit according to any one of claims 8, 10 and 11, **characterised in that** the energy transfer by coupling between the specific primary power supply circuit (16; 16') associated with an additional oscillatory circuit (12; 12') and the latter is a double coupling, where applicable with two substantially identical coupling areas affecting symmetrically and in an equivalent manner the conductors (13"; 14") of the additional transmission line portions (13, 13'; 14, 14') connected to the transmission line portions (3, 3') of the first oscillatory circuit (4).

13. Power supply circuit according to either of claims 11 and 12, when dependent on claim 10, **characterised in that** the or each coupling of the double coupling producing the energy transfer between a primary power supply circuit (16; 16') specific to an additional oscillatory circuit (12; 12') and the latter is magnetic coupling between, on the one hand, a segment (21; 21') of a conductor (13"; 14") of an additional line portion (13, 13'; 14, 14') connected to one of the line portions (3, 3') of the first oscillatory circuit (4) and, on the other hand, a segment (18, 18'; 19, 19') of the line connecting the generator (17; 17') to the matching component (20; 20') in the specific primary power supply circuit (16; 16') associated with the additional oscillatory circuit (12; 12') concerned, these two segments (21; 21' and 18, 18'; 19, 19') of particular length being disposed parallel to and near each other and forming Lecher lines.

14. Power supply circuit according to either of claims 11 and 12, when dependent on claim 10, **characterised in that** the coupling producing the energy transfer between the primary power supply circuit (16; 16') specific to an additional oscillatory circuit (12; 12') and the latter is symmetrical or asymmetrical magneto-capacitive coupling between, on the one hand, a solenoid (18; 19) connected in series in said specific primary power supply circuit (16; 16') and, on the other hand, a combination of a capacitor and inductor(s) (24; 24') connected in series in the additional oscillatory circuit (12; 12') concerned, which capacitor can correspond to the tuning components (6'; 6") and which inductor(s) can comprise two inductors (25, 25'; 26, 26') connected in series on either side of said capacitor (6', 6"), where applicable each forming part of an LC circuit.

15. Power supply circuit according to any one of claims 1 to 14, **characterised in that** the two additional line portions (13 and 13'; 14 and 14') forming part of said at least one or each additional oscillatory circuit (12; 12') are respectively connected to the line portions (3 and 3') forming part of the first oscillatory circuit (4) at non-interfering cold points (27, 27') of the conductors (5, 5') of the latter line portions (3 and 3').

16. Power supply circuit according to any one of claims 8 to 14, **characterised in that** the two additional line portions (13 and 13'; 14 and 14') forming part of said at least one additional oscillatory circuit (12; 12') are respectively connected to the line portions (3 and 3') forming part of the first oscillatory circuit (4) at the terminals of the tuning circuit or component (6) of said first oscillatory circuit (4).

17. Power supply circuit according to any one of claims 8 to 16, **characterised in that** the first oscillatory circuit (4) and/or the or at least one of the additional oscillatory circuits (12; 12') incorporates one or more tuned band stop isolating filters (28, 29), where applicable each tuned to the resonant frequency of the other or one of the other oscillatory circuit(s) (4, 12 or 12').

18. Power supply circuit according to claim 17, **characterised in that** the isolating filters (28, 29) take the form of a filter pair or pairs (28 or 29), each filter of a given pair of filters (28, 29) being connected in series to or in series with one of the conductors (5, 5') connected to the coil (2) of the first oscillatory circuit (4) or to one of the conductors (13"; 14") of the additional lines portions (13, 13'; 14, 14') of the additional oscillatory circuit (12 or 12') concerned, connected to a transmission line (3, 3') of the first oscillatory circuit (4).

19. Power supply circuit according to claim 17 or 18, **characterised in that** in the presence of a first oscillatory circuit (4) and two additional oscillatory circuits (12 and 12'), at least one of said oscillatory circuits (4, 12, 12') includes two pairs of isolating filters (28 and 29), each pair of filters (28, 29) being tuned to the resonant frequency of one oscillatory circuit (4, 12 or 12') of the other two oscillatory circuits (4, 12, 12'), the frequency of at least one of the filter pairs (29) being tunable, preferably continuously.

20. Power supply circuit according to either of claims 17 and 18, **characterised in that** the isolating filters (28, 29) consist of pairs of LC circuits, the pair(s) of filters (29), where applicable of tunable frequency, incorporating variable capacitors (30) variable continuously with mutual mechanical slaving (31) of their variation.

21. Power supply circuit according to any one of claims 8 to 20, **characterised in that** the transmission lines (3 and 3') forming part of the first oscillatory circuit (4) are coaxial lines, as are preferably the additional transmission lines (13, 13'; 14, 14').

22. Power supply circuit according to any one of claims 8 to 20, **characterised in that** the transmission lines (3 and 3') forming part of the first oscillatory circuit consist in portions of triaxial lines or lines with three concentric conductors (5, 5", 5""; 5',5"', 5""), at least the first oscillatory circuit (4) incorporating the conductors (5 and 5') connected directly to the coil (2) of said triaxial lines (3 and 3'), and at least one other of said oscillatory circuits (12, 12') incorporating additional concentric conductors (5" and 5"') of said triaxial lines (3 and 3'), a transfer of energy being effected between these respectively associated concentric conductors (5", 5"' and 5, 5') because of the distributed linear capacitance of said triaxial lines (3 and 3').

23. Power supply circuit according to claim 22, **characterised in that** the conductors (5 and 5') connected directly to the coil (2) of the triaxial lines (3 and 3') consist of the intermediate conductors of the latter and **in that** at least one of the additional oscillatory circuits (12, 12') is connected to and incorporates the central conductors (5" and 5"') not connected to the coil (2), the distributed linear capacitance between the central and intermediate conductors providing a connection by energy transfer enabling said additional oscillatory circuit (12, 12') concerned to be looped to the coil (2) via the intermediate conductors (5 and 5').

24. Power supply circuit according to claim 23, **characterised in that** the intermediate conductors (5 and 5') each have a physical break or discontinuity (34) at a respective non-interfering cold point (27, 27') and **in that** the additional line portions (13, 13'; 14, 14') of at least one of the additional oscillatory circuits (12, 12') are connected at said cold points to the portions of the intermediate connectors (5, 5') connected to the coil (2), the facing portions of said conductors (5 and 5') at said break or discontinuity (34) being connected to each other by frequency-selective energy transfer circuits (32), for example band-pass filters centred on the resonant frequency of the first oscillatory circuit (4) and transmitting the maximum energy for that frequency.

25. Power supply circuit according to claim 22, **characterised in that** the conductors (5 and 5') connected directly to the coil (2) of the triaxial lines (3 and 3') consist of the central conductors of the latter and **in that** at least one of the additional oscillatory circuits (12) incorporates the intermediate conductors (5" and 5"') not connected to the coil (2), the distributed linear capacitance between these central and intermediate conductors providing a connection by transfer of energy enabling said additional oscillatory circuit (12, 12') concerned to be looped to the coil (2) via the central conductors (5 and 5').

26. Power supply circuit according to claim 25, **characterised in that** the conductors (13"; 14") of the additional line portions (13, 13'; 14, 14') of at least one other additional oscillatory circuit (12') are connected to the central conductors (5 and 5') at non-interfering cold points (27, 27') of those conductors, **in that** the stop filters (29) isolate from each other the first oscillatory circuit (4) and the additional oscillatory circuit or circuits (12') the conductors (13", 14") of which are connected to said central conductors (5 and 5'), and **in that** the latter oscillatory circuits (4 and 12') are also, together, isolated from said at least one additional oscillatory circuit (12) incorporating the intermediate conductors (5" and 5"') not connected to the coil (2) by stop filters (28).

27. NMR probe, **characterised in that** it is provided with a power supply circuit (1) according to any one of claims 1 to 26 for the sampling coil (2).

28. NMR spectrometer, in particular for solid phase spectrometry, **characterised in that** it includes a power supply circuit (1) according to any one of claims 1 to 26 for the sample coil (2).

## Patentansprüche

1. Einspeisestromkreis einer HF-Spule oder Probenspule eines NMR-Gerätes, der zwei Abschnitte einer Übertragungsleitung umfasst, die jeweils mit einem der beiden Enden dieser Spule verbunden sind, wobei die Leitungsabschnitte mit der Spule einen ersten Schwingkreis (4) mit einer vorgegebenen Resonanzfrequenz bilden, wobei die beiden Leitungsabschnitte (3, 3') jeweils mindestens zwei Leiter (5, 5', 5", 5"') umfassen, wobei der eine (5, 5') mit der Spule (2) verbunden ist, und die untereinander identische Strukturen und identische Längen der verbundenen Leiter aufweisen,
**dadurch gekennzeichnet, dass** jede der identischen Längen im Wesentlichen ein Vielfaches der Hälfte der Resonanz-Wellenlänge des Schwingkreises (4) ist,
und dass die Leiter (5,5'), die mit der Spule (2) an einem ihrer Enden verbunden sind, untereinander an ihren anderen Enden durch einen Abstimmungsstromkreis oder eine regelbare, symmetrische Abstimmungskomponente (6), der/die diesen Schwingkreis (4) komplettiert, verbunden sind,
und dass der Schwingkreis (4) mit symmetrischer Struktur durch einen primären Einspeisestromkreis (7) mittels eines Energietransfers durch magnetische, kapazitive oder magneto-kapazitive Kopplung des primären Einspeisestromkreises (7) mit den beiden Leitern (5, 5'), die mit der Spule (2) und dem Abstimmungsstromkreis oder einer Abstimmungskomponente (6) verbunden sind, gespeist wird.

2. Einspeisestromkreis nach Anspruch 1, **dadurch gekennzeichnet, dass** der primäre Einspeisestromkreis (7) teilweise mit dem ersten Schwingkreis (4) übereinstimmt, indem ein Teil des Stromkreises (7'), in den ersten Schwingkreis integriert wird, und dass er einerseits einen Hochfrequenz-Generator (8) umfasst, der an die vorgegebene Resonanzfrequenz des ersten Schwingkreises (4) angepasst und mit diesem ersten Schwingkreis (4) auf dem Niveau einer Klemme des Abstimmungsstromkreises oder einer regelbaren, symmetrischen Abstimmungskomponente (6) mittels einer Kopplungskapazität (8') verbunden ist, und andererseits einen Anpassungsstromkreis oder eine Anpassungskomponente (10) umfasst, der/die mit der anderen Klemme des Stromkreises oder der regelbaren, symmetrischen Abstimmungskomponente (6) verbunden ist, wobei die Anpassungskomponente (10) und die regelbare, symmetrische Abstimmungskomponente (6) Teil der beiden Stromkreise (4 und 7) sind, aus Kapazitäten bestehen und der Generator (8) kontinuierlich, intermittierend oder pulsierend funktionieren kann.

3. Einspeisestromkreis nach Anspruch 1, **dadurch gekennzeichnet, dass** der primäre Einspeisestromkreis (7) aus einem getrennten Stromkreis besteht und zusätzlich zu einem Hochfrequenz-Generator (8), der an die vorgegebene Resonanzfrequenz des betroffenen Schwingkreises angepasst ist und des oder der Elements/e (9, 9'), die an der Kopplung mit den beiden Leitern (5, 5') eines oder der Leitungsabschnitte (3, 3'), die mit der Spule (2) verbunden sind, und dem Abstimmungsstromkreis oder der Abstimmungskomponente (6) teilhaben, auch einen Anpassungsstromkreis oder eine Anpassungskomponente (10) umfasst, die dazu bestimmt ist, die Kopplung zu optimieren und dabei bestimmte Effekte auf dem Niveau des primären Einspeisestromkreises (7) zu begrenzen, wobei der Generator (8) kontinuierlich, intermittierend oder pulsierend funktionieren kann.

4. Einspeisestromkreis nach einem der Ansprüche 1 und 3, **dadurch gekennzeichnet, dass** die Kopplung eine im Wesentlichen magnetische Kopplung ist, und dass der Anpassungsstromkreis oder die Anpassungskomponente (10) eine regelbare Kapazität ist, die zur Annulierung der induktiven Reaktanz auf dem Niveau des primären Einspeisestromkreises (7) bestimmt ist

5. Einspeisestromkreis nach einem der Ansprüche 1, 3 und 4, **dadurch gekennzeichnet, dass** der Energietransfer durch Kopplung zwischen dem primären Einspeisestromkreis (7) und dem Schwingkreis (4) aus einer Doppelkopplung besteht und symmetrisch und äquivalent die mit der Spule (2) verbundenen Leiter (5 und 5'; 5", 5"') der beiden Abschnitte der Übertragungsleitung (3 und 3') beeinflussen.

6. Einspeisestromkreis nach einem der Ansprüche 4 und 5, sofern sie von Anspruch 3 abhängen, **dadurch gekennzeichnet, dass** die oder jede der beiden Kopplung(en), die den Energietransfer realisieren, in einer im Wesentlichen magnetischen Kopplung zwischen einerseits einem Segment (11) eines mit der Spule (2) verbundenen Leiters (5, 5') eines der Leitungsabschnitte (3, 3') des Schwingkreises (4) und andererseits einem Segment (9, 9') der Leitung, die den Generator (8) mit der Anpassungskomponente (10) in dem primären Einspeisestromkreis (7) verbindet, besteht, wobei diese beiden Segmente (11 und 9, 9') vorgegebener Längen parallel und in der Nähe zueinander angeordnet sind, so dass sie Lecherleitungen bilden.

7. Einspeisestromkreis nach einem der Ansprüche 4 und 5, sofern sie von Anspruch 3 abhängen, **dadurch gekennzeichnet, dass** die Kopplung zum Energietransfer aus einer asymmetrischen, symmetrischen, magneto-kapazitiven Kopplung besteht, zwischen einerseits einer Zylinderspule (9), die in Serie in den primären Einspeisestromkreis (7) geschaltet ist, und andererseits einer Kapazität(en)/Induktanz(en)-Anordnung (11'), die in Serie in den Schwingkreis (4) geschaltet ist, wobei die Kapazität mit der Abstimmungskomponente (6) wechselwirken kann und wobei die Induktanzen zwei äquivalente Induktanzen (15, 15') umfassen können, die in Serie auf beiden Seiten der Kapazität (6) geschaltet sind, wobei sie gegebenenfalls jeweils Teil eines LC-Stromkreises sein können .

8. Einspeisestromkreis nach einem der Ansprüche 1 bis 7, **dadurch gekennzeichnet, dass** er wenigstens einen zusätzlichen Schwingkreis (12, 12'), der eine Resonanzfrequenz aufweist, die sich von derjenigen des ersten Schwingkreises (4) unterscheidet und gegebenenfalls jeweils gebildet ist durch die Spule (2), gegenseitig äquivalente Teile eines Leiters (5, 5', 5", 5"') der beiden Leitungsabschnitte (3, 3') des ersten Schwingkreises (4) und, eventuell, zwei zusätzliche Abschnitte der Übertragungsleitung (13, 13'; 14, 14'), die jeweils durch eines der Enden ihres wenigstens einen Leiters (13", 14") jeweils mit einem der Leiter (5, 5" ; 5', 5"') eines der beiden oben genannten Leitungsabschnitte (3, 3') verbunden sind und untereinander identische Längen und Strukturen aufweisen, umfasst, und dass die Summe der Länge von jedem der beiden zusätzlichen Abschnitte der Übertragungsleitungen (13, 13' ; 14, 14') und der Länge des Leiterteils (5, 5', 5", 5"'), der jeweils mit einem der beiden Leitungsabschnitte (3, 3') verbunden ist, ein Vielfaches der Resonanz-Halbwellenlänge des betrachteten zusätzlichen Schwingkreises (12, 12') beträgt, dass die zusätzlichen Übertragungsleitungen (13, 13' ; 14, 14') mit ihrem anderen Ende mit einem Abstimmungsstromkreis oder einer Abstimmungskomponente (6, 6") verbunden sind, und dass der wenigstens eine oder jede zusätzliche Schwingkreis (12, 12') durch einen entsprechenden eigenen primären Einspeisestromkreis (16, 16') gespeist wird und zwar mittels eines Energietransfers durch magnetische, kapazitive oder magneto-kapazitive Kopplung dieses entsprechenden jeweiligen primären Einspeisestromkreises (16, 16') mit wenigstens einem der Leiter (13" ; 14") von wenigstens einem der beiden zusätzlichen Abschnitte der Übertragungsleitung (13, 13'; 14, 14"), die mit den Leitungsabschnitten (3, 3') des ersten Schwingkreises (4) verbunden oder Teil davon sind.

9. Einspeisestromkreis nach Anspruch 8, **dadurch gekennzeichnet, dass** der primäre Einspeisestromkreis (16, 16'), der jedem zusätzlichen Schwingkreis (12, 12') eigen ist, teilweise mit dem zusätzlichen verbundenen Schwingkreis übereinstimmt, indem ein Teil des Stromkreises, der mit diesem zusätzlichen Schwingkreis gemeinsam ist, integriert wird, und dass er einerseits einen Hochfrequenz-Generator beinhaltet, der an die vorgegebene Resonanzfrequenz des betreffenden zusätzlichen Schwingkreises angepasst und mit letzterem auf dem Niveau einer Klemme des Abstimmungsstromkreises oder einer regelbaren, symmetrischen Abstimmungskomponente des zusätzlichen Schwingkreises mittels einer Kopplungskapazität verbunden ist, und andererseits einen Anpassungsstromkreis oder eine Anpassungskomponente beinhaltet, der/die mit der anderen Klemme des Abstimmungsstromkreises oder der vorher genannten regelbaren, symmetrischen Abstimmungskomponente verbunden ist, wobei die Anpassungskomponente und die regelbare, symmetrische Abstimmungskomponente, die Teil der beiden Stromkreise sind, aus Kapazitäten bestehen.

10. Einspeisestromkreis nach Anspruch 8, **dadurch gekennzeichnet, dass** der primäre Einspeisestromkreis (16, 16'), der jedem zusätzlichen Schwingkreis (12, 12') eigen ist, zusätzlich zu einem Hochfrequenz-Generator (17, 17'), der an die vorbestimmte Resonanzfrequenz angepasst ist und des oder der Elemente(s) (18, 18' ; 19, 19'), die an der Kopplung mit dem mindestens einen Leiter (13" ; 14") der zusätzlichen Leitungsabschnitte (13', 13" ; 14', 14") teilhaben, einen Anpassungsstromkreis oder Anpassungskomponente (20, 20') beinhaltet, die zur Optimierung der Kopplung und dabei zur Begrenzung von bestimmten Effekten auf dem Niveau des eigenen primären Einspeisestromkreises (16 ; 16') bestimmt ist, wobei der Generator (17, 17') kontinuierlich, intermittierend oder pulsierend funktionieren kann.

11. Einspeisestromkreis nach einem der Ansprüche 8 und 10, **dadurch gekennzeichnet, dass** die Kopplung mit Energietransfer zwischen dem oder jedem zusätzlichen Schwingkreis (12, 12') und seinem eigenen primären oder jeweils verbundenen Einspeisestromkreis (16 ; 16') in einer im Wesentlichen magnetischen Kopplung besteht, und dass der Anpassungsstromkreis oder die Anpassungskomponente (20, 20') eine regelbare Kapazität ist, die zur Annulierung der induktiven Reaktanz auf dem Niveau des betrachteten eigenen primären Einspeisestromkreises (16, 16') bestimmt ist.

12. Einspeisestromkreis nach einem der Ansprüche 8, 10 und 11, **dadurch gekennzeichnet, dass** der Energietransfer durch Kopplung zwischen dem eigenen primären Einspeisestromkreis (16, 16'), der mit einem zusätzlichen Schwingkreis (12, 12') verbunden ist und dass letzterer aus einer Doppelkopplung besteht mit gegebenenfalls zwei im Wesentlichen identischen Kopplungszonen, die die Leiter (13" ; 14") der zusätzlichen Abschnitte der Übertragungsleitungen (13, 13' ; 14, 14'), die mit den Abschnitten der Übertragungsleitung (3, 3') des ersten Schwingkreises (4) verbunden sind, symmetrisch und äquivalent beeinflusst.

13. Einspeiseleitung nach einem der Ansprüche 11 und 12, sofern sie mit Anspruch 10 in Zusammenhang stehen, **dadurch gekennzeichnet, dass** die oder jede der beiden Kopplung(en), die den Energietransfer zwischen einem einem zusätzlichen Schwingkreis (12 ; 12') eigenen primären Einspeisestromkreis (16, 16') und dem letzteren realisieren, aus einer magnetischen Kopplung zwischen einerseits einem Segment (21 ; 21') eines Leiters (13" ; 14") eines zusätzlichen Leitungsabschnitts (13, 13' ; 14, 14'), der mit einem der Leitungsabschnitte (3, 3') des ersten Schwingkreises (4) verbunden ist, und andererseits einem Segment (18, 18' ; 19, 19') der Leitung, die den Generator (17 ; 17') mit der Anpassungskomponente (20 ; 20') in dem eigenen primären Einspeisestromkreis (16 ; 16'), der mit dem betreffenden zusätzlichen Schwingkreis (12 ; 12') verbunden ist, besteht(en), wobei diese beiden Segmente (21 ; 21' und 18, 18' ; 19, 19') mit bestimmten Längen parallel und in der Nähe zueinander angeordnet sind und die Lecherleitungen bilden.

14. Einspeisestromkreis nach einem der Ansprüche 11 und 12, sofern sie mit Anspruch 10 in Zusammenhang stehen, **dadurch gekennzeichnet, dass** die Kopplung zum Energietransfer zwischen dem primären Einspeisestromkreis (16 ; 16'), der einem zusätzlichen Schwingkreis (12 ; 12') eigen ist und diesem letzteren aus einer asymmetrischen, symmetrischen oder magneto-kapazitiven Kopplung besteht, zwischen einerseits einer Zylinderspule (18 ; 19), die in Serie in den eigenen primären Einspeisestromkreis (16 , 16') geschaltet ist, und andererseits einer Kapazität(en)/Induktanz(en)-Anordnung (24 ; 24'), die in Serie in den betreffenden zusätzlichen Schwingkreis (12 ; 12') geschaltet ist, wobei die Kapazität mit der Abstimmungskomponente (6' ; 6") wechselwirken kann und wobei die Induktanzen zwei Induktanzen (25, 25' ; 26, 26') umfassen können, die in Serie auf beiden Seiten der Kapazität (6' ; 6") geschaltet sein können, wobei sie gegebenenfalls jeweils Teil eines LC-Stromkreises sein können.

15. Einspeisestromkreis nach einem der Ansprüche 1 bis 14, **dadurch gekennzeichnet, dass** die beiden zusätzlichen Leitungsabschnitte (13 und 13' ; 14 und 14'), die Teil des wenigstens einen oder jedes zusätzlichen Schwingkreises (12 ; 12') sind, jeweils mit den Leitungsabschnitten (3 und 3') verbunden sind, die Teil des ersten Schwingkreises (4) auf dem Niveau von nicht interferierenden kalten Punkten (27, 27') der Leiter (5, 5') von diesen letzteren Leitungsabschnitten (3 und 3') sind.

16. Einspeisestromkreis nach einem der Ansprüche 8 bis 14, **dadurch gekennzeichnet, dass** die beiden zusätzlichen Leitungsabschnitte (13 und 13' ; 14 und 14'), die Teil des wenigstens einen zusätzlichen Schwingkreises (12 ; 12') sind, jeweils mit den Leitungsabschnitten (3 und 3') verbunden sind, die Teil des ersten Schwingkreises (4), auf dem Niveau der Klemmen des Abstimmungsstromkreises oder der Abstimmungskomponente (6) des ersten Schwingkreises (4) sind.

17. Einspeisestromkreis nach einem der Ansprüche 8 bis 16, **dadurch gekennzeichnet, dass** der erste Schwingkreis (4) und/oder der oder wenigstens einer der zusätzliche(n) Schwingkreis(e) (12 ; 12') einen oder geeignete(n) Band-Unterdrückungs-Isolationsfilter (28, 29) integriert(en), die gegebenenfalls auf die Resonanzfrequenz des anderen oder von einem der anderen Schwingkreise(s) (4, 12 oder 12') angepasst sind.

18. Einspeisestromkreis nach Anspruch 17, **dadurch gekennzeichnet, dass** sich die Isolationsfilter (28, 29) in Form von Filterpaar(en) (28 oder 29) darstellen, wobei jeder Filter eines gegebenen Paares von Filtern (28, 29) in Serie verbunden ist oder mit einem der Leiter (5, 5'), die mit der Spule (2) des ersten Schwingkreises (4) oder mit einem der Leiter (13" ; 14") der zusätzlichen Leitungsabschnitte (13, 13' ; 14, 14') des betreffenden zusätzlichen Schwingkreises (12 oder 12'), der mit einer Übertragungsleitung (3, 3') des ersten Schwingkreises (4) verbunden ist, in Serie geschaltet ist.

19. Einspeisestromkreis nach Anspruch 17 oder 18, **dadurch gekennzeichnet, dass** beim Vorhandensein eines ersten Schwingkreises (4) und zweier zusätzlicher Schwingkreise (12 und 12') in mindestens einem der Schwingkreise (4, 12, 12') zwei Paare von Isolationsfiltern (28 und 29) integriert sind, wobei jedes Filterpaar (28, 29) auf die Resonanzfrequenz eines (4, 12 oder 12') der beiden anderen Schwingkreise (4, 12, 12') eingestellt ist, wobei eines der Filterpaare (29) mindestens hinsichtlich der Frequenz, vorzugsweise kontinuierlich, regelbar ist.

20. Einspeisestromkreis nach einem der Ansprüche 17 und 18, **dadurch gekennzeichnet, dass** die Isolationsfilter (28, 29) aus Paaren von LC-Stromkreisen bestehen, wobei in das Paar oder die Paare von Filtern (29), das/die gegebenenfalls hinsichtlich der Frequenz steuerbar ist/sind, fortlaufend variable Kapazitäten (30) mit einem wechselseitigen mechanischen Steuergerät (31) zu ihrer Steuerung integriert sind.

21. Einspeisestromkreis nach einem der Ansprüche 8 bis 20, **dadurch gekennzeichnet, dass** die Übertragungsleitungen (3 und 3'), die Teil des ersten Schwingkreises (4) sind, aus koaxialen Leitungen sowie vorzugsweise zusätzlichen Übertragungsleitungen (13, 13' ; 14, 14') bestehen.

22. Einspeisestromkreis nach einem der Ansprüche 8 bis 20, **dadurch gekennzeichnet, dass** die Übertragungsleitungsabschnitte (3 und 3'), die Teil des ersten Schwingkreises sind, in Abschnitten von triaxialen Leitungen oder Leitungen mit drei konzentrischen Leitern (5, 5", 5"" ; 5', 5"', 5"") bestehen, wobei wenigstens der erste Schwingkreis (4) die Leiter (5 und 5') integriert, die direkt mit der Spule (2) der triaxialen Leitungen (3 und 3') verbunden sind und mindestens einen der anderen Schwingkreise (12, 12'), der die zusätzlichen konzentrischen Leiter (5" und 5"') der triaxialen Leitungen (3 und 3') integriert, wobei ein Energietransfer zwischen diesen jeweils verbundenen, konzentrischen Leitern (5", 5"' und 5, 5') aufgrund der verteilten linienförmigen Kapazität der triaxialen Leitungen (3 und 3') erfolgt.

23. Einspeisestromkreis nach Anspruch 22, **dadurch gekennzeichnet, dass** die Leiter (5 und 5'), die direkt mit der Spule (2) der triaxialen Leitungen (3 und 3') verbunden sind, durch die Zwischenleiter von letzteren gebildet sind, und dass mindestens einer der zusätzlichen Schwingkreise (12, 12') mit den zentralen Leitern (5" und 5"'), die nicht mit der Spule (2) verbunden sind, verbunden ist und diese integriert, wobei die linienförmige, zwischen diesen zentralen Leitern und Zwischenleitern verteilte Kapazität eine Kopplungsverbindung durch Energietransfer bereitstellt, die es diesem betreffenden zusätzlichen Schwingkreis (12, 12') ermöglicht, sich mit der Spule (2) mittels der Zwischenleiter (5 und 5') zu einer Schleife zu schalten.

24. Einspeisestromkreis nach Anspruch 23, **dadurch gekennzeichnet, dass** die Zwischenleiter (5 und 5') jeweils eine physikalische Unterbrechung oder Diskontinuität (34) auf dem Niveau eines jeweils nicht interferierenden, kalten Punktes (27, 27') aufweisen, und dass die zusätzlichen Leiterabschnitte (13, 13' ; 14, 14') des mindestens einen zusätzlichen Schwingkreises (12, 12') auf dem Niveau der kalten Punkte mit den mit der Spule (2) verbundenen Teilen der Zwischenleiter (5, 5') verbunden sind, wobei die Teile der Leiter (5 und 5') gegenüber auf dem Niveau der Unterbrechung oder der Diskontinuität (34) untereinander durch Energietransferstromkreise (32) verbunden sind, die hinsichtlich der Frequenz selektiv sind, beispielsweise Bandfilter, die auf die Resonanzfrequenz des ersten Schwingkreises (4) getrimmt sind und das Maximum an Energie für diese Frequenz übertragen.

25. Einspeisestromkreis nach Anspruch 22, **dadurch gekennzeichnet, dass** die Leiter (5 und 5'), die direkt mit der Spule (2) der triaxialen Leitungen (3 und 3') verbunden sind, durch die zentralen Leiter von letzteren gebildet sind, und dass mindestens einer der zusätzlichen Schwingkreise (12) die nicht mit der Spule (2) verbundenen Zwischenleiter (5" und 5"') integriert, wobei die linienförmige, zwischen diesen zentralen Leitern und Zwischenleitern verteilte Kapazität eine Energietransferverbindung bereitstellt, die es diesem betreffenden zusätzlichen Schwingkreis (12, 12') ermöglicht, sich mit der Spule (2) mittels der zentralen Leiter (5 und 5') zu einer Schleife zu schalten.

26. Einspeisestromkreis nach Anspruch 25, **dadurch gekennzeichnet, dass** die Leiter (13" ; 14") der zusätzlichen Leiterabschnitte (13, 13' ; 14, 14') mindestens eines anderen zusätzlichen Schwingkreises (12') auf dem Niveau von nicht interferierenden, kalten Punkten (27, 27') dieser Leiter mit den zentralen Leitern (5 und 5') verbunden sind, dass Sperrfilter (29) untereinander den ersten Schwingkreis (4) und den oder die zusätzlichen Schwingkreis(e) (12'), deren Leiter (13", 14") mit den zentralen Leitern (5 und 5') verbunden sind, isolieren, und dass diese letzteren Schwingkreise (4 und 12') auch zugleich von diesem mindestens einen zusätzlichen Schwingkreis (12), der die nicht mit der Spule (2) verbundenen Zwischenleiter (5" und 5"') integriert, durch Sperrfilter (28) isoliert sind.

27. NMR-Sonde, **dadurch gekennzeichnet, dass** sie mit einem Einspeisestromkreis (1) der Probenspule (2) nach einem der Ansprüche 1 bis 26 versehen ist.

28. NMR-Spektrometer, insbesondere für die Spektrometrie von festen Phasen, **dadurch gekennzeichnet, dass** es einen Einspeisestromkreis (1) der Probenspule (2) nach einem der Ansprüche 1 bis 26 aufweist.
